# EUROPEAN PATENT SPECIFICATION

(11) **EP 2 224 598 B1**
(45) Date of publication and mention of the grant of the patent: **10.07.2013**
(21) Application number: 09154030.2
(22) Date of filing: 27.02.2009
(51) Int. Cl.: H03M 7/30

(54) **Method and apparatus for creating side information from data for use in interactive compression**
Verfahren und Vorrichtung zur Erzeugung von Seiteninformation aus Daten zur Verwendung in der interaktiven Komprimierung
Procédé et appareil pour créer des informations latérales à partir des données en cours d'utilisation dans une compression interactive

(43) Date of publication of application: 01.09.2010
(73) Proprietor: Research In Motion Limited, Waterloo, ON N2L 3W8 (CA)
(72) Inventor: Ahmed, Salmaan, Waterloo, Ontario N2L 5Z5 (CA); Sze, David P., Kitchener, Ontario N2G 4Z6 (CA)
(74) Representative: Moore, Barry

(56) References cited:
- WO-A1-2008/144876
- MARCEL-CATALIN ROSU ED: "A-SOAP: Adaptive SOAP Message Processing and Compression" WEB SERVICES, 2007. ICWS 2007. IEEE INTERNATIONAL CONFERENCE ON, IEEE, PI, 1 July 2007 (2007-07-01), pages 200-207, XP031119917 ISBN: 978-0-7695-2924-0
- TOAN NGUYEN DINH ET AL: "Side Information Generation Using Extra Information in Distributed Video Coding" SIGNAL PROCESSING AND INFORMATION TECHNOLOGY, 2007 IEEE INTERNATIONAL SYMPOSIUM ON, IEEE, PISCATAWAY, NJ, USA, 15 December 2007 (2007-12-15), pages 138-143, XP031234293 ISBN: 978-1-4244-1834-3

## Description

### FIELD OF TECHNOLOGY

The present disclosure relates to a method of creating side information for use in interactive compression.

### BACKGROUND

In the field of data communication, data is typically compressed so that the amount of information being transmitted is reduced. Such data compression enables less traffic and therefore faster transmission. Compression also reduces storage requirements, which is especially important in communication to portable or mobile communication devices with limited storage capacity. In conventional communication between a server and a mobile communication device, requested data, such as message data, a website, or a digital file, is encoded, or compressed, by the server, and then transmitted. A decoder at the mobile communication device decodes the compressed data, and processes it appropriately, for example, displaying it to the user.

Side information, or a priori information shared by both the encoder and decoder, can be used in the compression and decompression of transmitted data to improve compression performance. The choice of side information influences the compression ratio achieved by the compression. Significantly improved compression can be achieved in systems, known as interactive compression systems, that maintain shared caches of side information. A class of such systems is grammar-based compression of which Yang-Kieffer (YK) data compression is a member. Side information that is correlated with the data being compressed is utilized in YK compression to build a grammar and collect frequency counts. This is used to achieve better compression of the data being compressed.

"A-SOAP: Adaptive SOAP Message Processing and Compression" by Marcel-Catalin Rosu discloses a dictionary based compression scheme known as adaptive simple object access protocol (A-SOAP) in which the dictionaries used by endpoints are built incrementally as communication between the endpoints progresses.

It is important that both encoder and decoder use the same side information in compression and decompression, thereby using the same parameters (e.g. YK grammar and frequency counts) for compression and decompression, respectively. While such compression and decompression systems and techniques provide significant compression of data, the compression and decompression occurs at the expense of the use of limited resources on mobile devices.

### SUMMARY

According to one aspect, there is provided a computer-implemented method of creating side information from data for use in interactive compression. The method includes identifying constituents of the data comprising displayable data including text data, and structure and formatting information, determining a node tree structure for the identified constituents of the data using the structure and formatting information,
determining, for each node in the node-tree structure, a ratio of the number of child nodes of that node to a total length of text data of that node and the child nodes of that node, determining ones of the constituents of the data to retain to use as a unit of side information based on the ratio such that each node and the respective child nodes are retained when the ratio for the node exceeds a predetermined value, each node for which the ratio is not zero is retained, and each node that is not a node of text data for rendering and for which the ratio is equal to zero is retained; and extracting and retaining the determined ones of the constituents of the data to use as a unit of side information.

According to another aspect, there is provided a mobile device including a housing, a display device exposed by the housing, an input device, a memory unit within the housing, and a processor within the housing and operably connected to the display device, the input device and the memory unit for executing a program stored in the memory unit to cause the electronic device to create side information from data for use in interactive compression. The side information is created by identifying constituents of the data comprising displayable data including text data, and structure and formatting information, determining a node tree structure for the identified constituents of the data using the structure and formatting information, determining, for each node in the node-tree structure, a ratio of the number of child nodes of that node to a total length of text data of that node and the child nodes of that node, determining ones of the constituents of the data to retain to use as a unit of side information based on the ratio such that each node and the respective child nodes are retained when the ratio for the node exceeds a predetermined value, each node for which the ratio is not zero is retained, and each node that is not a node of text data for rendering and for which the ratio is equal to zero is retained; and extracting and retaining the determined ones of the constituents of the data to use as a unit of side information.

According to yet another aspect, there is provided a computer program product including a computer-readable medium having computer-readable code embodied therein for execution by a processor of a mobile device to create side information from data to use in interactive compression by identifying constituents of the data comprising displayable data including text data, and structure and formatting information, determining a node tree structure for the identified constituents of the data using the structure and formatting information, determining, for each node in the node-tree structure, a ratio of the number of child nodes to a length of text data, determining ones of the constituents of the data to retain to use as a unit of side information based on the ratio such that each node and the respective child nodes are retained when the ratio for the node exceeds a predetermined value, each node for which the ratio is not zero is retained, and each node that is not a node of text data for rendering and for which the ratio is equal to zero is retained; and extracting and retaining the determined ones of the constituents of the data to use as a unit of side information.

Other aspects and features of the present disclosure will become apparent to those ordinarily skilled in the art upon review of the following description of specific embodiments of the disclosure in conjunction with the accompanying figures.

### BRIEF DESCRIPTION OF THE DRAWINGS

Embodiments of the present disclosure will now be described, by way of example only, with reference to the attached Figures, wherein:
Figure 1 is a block diagram of an exemplary embodiment of a mobile communication device;
Figure 2 is a block diagram of an exemplary embodiment of a communication subsystem component of the mobile device of Figure 1;
Figure 3 is an exemplary block diagram of a node of a wireless network;
Figure 4 is a block diagram illustrating components of a host system in one exemplary configuration for use with the wireless network of Figure 3 and the mobile communication device of Figure 1;
Figure 5 is a schematic view of a mobile communication device and a server:
Figure 6 is a flowchart showing a method of interactive compression for communication between the server and the mobile communication device;
Figure 7 is a flowchart a flowchart showing further steps in a method of interactive compression for communication between the server and the mobile device;
Figure 8 shows a simplified example of data retrieved by a server;
Figure 9 shows the data of Figure 8 after reducing the data in accordance with an aspect of an embodiment;
Figure 10 is a flowchart showing sub-steps in the method of Figure 6 according to the embodiment;
Figures 11A and 11B show a simplified example of data retrieved by the server;
Figures 12 and 13 show hierarchical node tree structures representing the data of Figures 11A and 11B;
Figure 14 shows a hierarchical node tree structure of the data of Figures 11A and 11B after reduction of the data in accordance with the method of Figures 6, 7 and 10; and
Figure 15 shows the data of Figures 11A and 11B after reduction of the data in accordance with the method of Figures 6, 7 and 10.

### DESCRIPTION OF PREFERRED EMBODIMENTS

Generally, described is a system and method for creating side information from data for use in interactive compression between parties, such as a server and a mobile communication device. In an embodiment, the interactive data compression is performed using a lossless data compression, such as that described in U.S. Patent No. 6,801,141 to Yang et al. This type of data compression, using grammar transforms, or rules, is also known as Yang-Kieffer (YK) data compression. In YK data compression, data is compressed into an irreducible grammar form from which the original data may be recovered. The grammar form of previously compressed data can be used in compression of related data, particularly when dealing with data having similar properties and/or content. This grammar form can be used for subsequent compressions by storing parameters, such as the actual grammar production rules and frequency counts, as compression state information, and can result in much enhanced compression, particularly in terms of increased speed of compression and reduced use of processing resources.

It will be appreciated that for simplicity and clarity of illustration, where considered appropriate, reference numerals may be repeated among the figures to indicate corresponding or analogous elements. In addition, numerous specific details are set forth in order to provide a thorough understanding of the embodiments described herein. However, it will be understood by those of ordinary skill in the art that the embodiments described herein may be practiced without these specific details. In other instances, well-known methods, procedures and components have not been described in detail so as not to obscure the embodiments described herein. Also, the description is not to be considered as limiting the scope of the embodiments described herein.

The embodiments described herein generally relate to a mobile wireless communication device, hereafter referred to as a mobile device. Examples of applicable communication devices include pagers, cellular phones, cellular smart-phones, wireless organizers, personal digital assistants, computers, laptops, handheld wireless communication devices, wirelessly enabled notebook computers and the like.

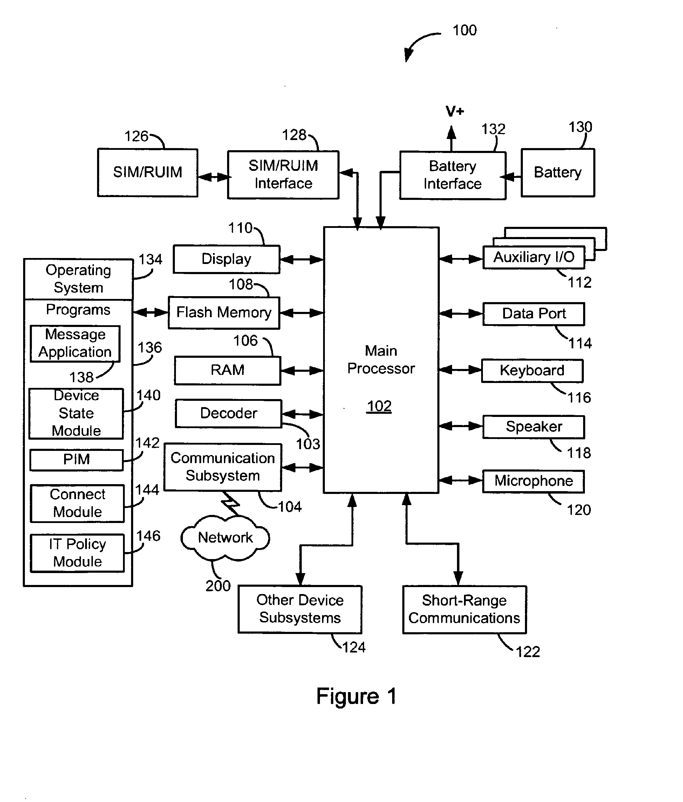

The mobile device is a two-way communication device with advanced data communication capabilities including the capability to communicate with other mobile devices or computer systems through a network of transceiver stations. The mobile device may also have the capability to allow voice communication. Depending on the functionality provided by the mobile device, it may be referred to as a data messaging device, a two-way pager, a cellular telephone with data messaging capabilities, a wireless Internet appliance, or a data communication device (with or without telephony capabilities). To aid the reader in understanding the structure of the mobile device and how it communicates with other devices and host systems, reference will now be made to Figures 1 through 4.

Referring first to Figure 1, shown therein is a block diagram of an exemplary embodiment of a mobile device 100. The mobile device 100 includes a number of components such as a main processor 102 that controls the overall operation of the mobile device 100. Communication functions, including data and voice communications, are performed through a communication subsystem 104. Data received by the mobile device 100 can be decompressed and decrypted by decoder 103, operating according to any suitable decompression techniques (e.g. YK decompression, and other known techniques) and encryption techniques (e.g. using an encryption techniques such as Data Encryption Standard (DES), Triple DES, or Advanced Encryption Standard (AES)). The communication subsystem 104 receives messages from and sends messages to a wireless network 200. In this exemplary embodiment of the mobile device 100, the communication subsystem 104 is configured in accordance with the Global System for Mobile Communication (GSM) and General Packet Radio Services (GPRS) standards. The GSM/GPRS wireless network is used worldwide and it is expected that these standards will be superseded eventually by Enhanced Data GSM Environment (EDGE) and Universal Mobile Telecommunications Service (UMTS). New standards are still being defined, but it is believed that they will have similarities to the network behavior described herein, and it will also be understood by persons skilled in the art that the embodiments described herein are intended to use any other suitable standards that are developed in the future. The wireless link connecting the communication subsystem 104 with the wireless network 200 represents one or more different Radio Frequency (RF) channels, operating according to defined protocols specified for GSM/GPRS communications. With newer network protocols, these channels are capable of supporting both circuit switched voice communications and packet switched data communications.

Although the wireless network 200 associated with mobile device 100 is a GSM/GPRS wireless network in one exemplary implementation, other wireless networks may also be associated with the mobile device 100 in variant implementations. The different types of wireless networks that may be employed include, for example, data-centric wireless networks, voice-centric wireless networks, and dual-mode networks that can support both voice and data communications over the same physical base stations. Combined dual-mode networks include, but are not limited to, Code Division Multiple Access (CDMA) or CDMA2000 networks, GSM/GPRS networks (as mentioned above), and future third-generation (3G) networks like EDGE and UMTS. Some other examples of data-centric networks include WiFi 802.11, Mobitex™ and DataTAC™ network communication systems. Examples of other voice-centric data networks include Personal Communication Systems (PCS) networks like GSM and Time Division Multiple Access (TDMA) systems. The main processor 102 also interacts with additional subsystems such as a Random Access Memory (RAM) 106, a flash memory 108, a display 110, an auxiliary input/output (I/O) subsystem 112, a data port 114, a keyboard 116, a speaker 118, a microphone 120, short-range communications 122 and other device subsystems 124.

Some of the subsystems of the mobile device 100 perform communication-related functions, whereas other subsystems may provide "resident" or on-device functions. By way of example, the display 110 and the keyboard 116 may be used for both communication-related functions, such as entering a text message for transmission over the network 200, and device-resident functions such as a calculator or task list.

The mobile device 100 can send and receive communication signals over the wireless network 200 after required network registration or activation procedures have been completed. Network access is associated with a subscriber or user of the mobile device 100. To identify a subscriber, the mobile device 100 requires a SIM/RUIM card 126 (i.e. Subscriber Identity Module or a Removable User Identity Module) to be inserted into a SIM/RUIM interface 128 in order to communicate with a network. The SIM card or RUIM 126 is one type of a conventional "smart card" that can be used to identify a subscriber of the mobile device 100 and to personalize the mobile device 100, among other things. Without the SIM card 126, the mobile device 100 is not fully operational for communication with the wireless network 200. By inserting the SIM card/RUIM 126 into the SIM/RUIM interface 128, a subscriber can access all subscribed services. Services may include: web browsing and messaging such as e-mail, voice mail, Short Message Service (SMS), and Multimedia Messaging Services (MMS). More advanced services may include: point of sale, field service and sales force automation. The SIM card/RUIM 126 includes a processor and memory for storing information. Once the SIM card/RUIM 126 is inserted into the SIM/RUIM interface 128, it is coupled to the main processor 102. In order to identify the subscriber, the SIM card/RUIM 126 can include some user parameters such as an International Mobile Subscriber Identity (IMSI). An advantage of using the SIM card/RUIM 126 is that a subscriber is not necessarily bound by any single physical mobile device. The SIM card/RUIM 126 may store additional subscriber information for a mobile device as well, including datebook (or calendar) information and recent call information. Alternatively, user identification information can also be programmed into the flash memory 108.

The mobile device 100 is a battery-powered device and includes a battery interface 132 for receiving one or more rechargeable batteries 130. In at least some embodiments, the battery 130 can be a smart battery with an embedded microprocessor. The battery interface 132 is coupled to a regulator (not shown), which assists the battery 130 in providing power V+ to the mobile device 100. Although current technology makes use of a battery, future technologies such as micro fuel cells may provide the power to the mobile device 100.

The mobile device 100 also includes an operating system 134 and software components 136 to 146 which are described in more detail below. The operating system 134 and the software components 136 to 146 that are executed by the main processor 102 are typically stored in a persistent store such as the flash memory 108, which may alternatively be a read-only memory (ROM) or similar storage element (not shown). Those skilled in the art will appreciate that portions of the operating system 134 and the software components 136 to 146, such as specific device applications, or parts thereof, may be temporarily loaded into a volatile store such as the RAM 106. Other software components can also be included, as is well known to those skilled in the art.

The subset of software applications 136 that control basic device operations, including data and voice communication applications, will normally be installed on the mobile device 100 during its manufacture. Other software applications include a message application 138 that can be any suitable software program that allows a user of the mobile device 100 to send and receive electronic messages. Various alternatives exist for the message application 138 as is well known to those skilled in the art. Messages that have been sent or received by the user are typically stored in the flash memory 108 of the mobile device 100 or some other suitable storage element in the mobile device 100. In at least some embodiments, some of the sent and received messages may be stored remotely from the device 100 such as in a data store of an associated host system that the mobile device 100 communicates with.

The software applications can further include a device state module 140, a Personal Information Manager (PIM) 142, and other suitable modules (not shown). The device state module 140 provides persistence, i.e. the device state module 140 ensures that important device data is stored in persistent memory, such as the flash memory 108, so that the data is not lost when the mobile device 100 is turned off or loses power.

The PIM 142 includes functionality for organizing and managing data items of interest to the user, such as, but not limited to, e-mail, contacts, calendar events, voice mails, appointments, and task items. A PIM application has the ability to send and receive data items via the wireless network 200. PIM data items may be seamlessly integrated, synchronized, and updated via the wireless network 200 with the mobile device subscriber's corresponding data items stored and/or associated with a host computer system. This functionality creates a mirrored host computer on the mobile device 100 with respect to such items. This can be particularly advantageous when the host computer system is the mobile device subscriber's office computer system.

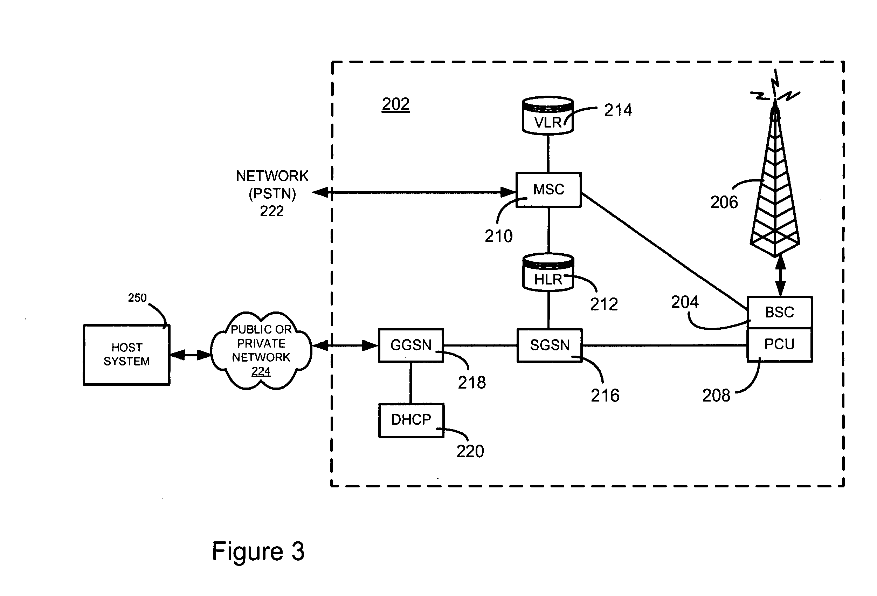

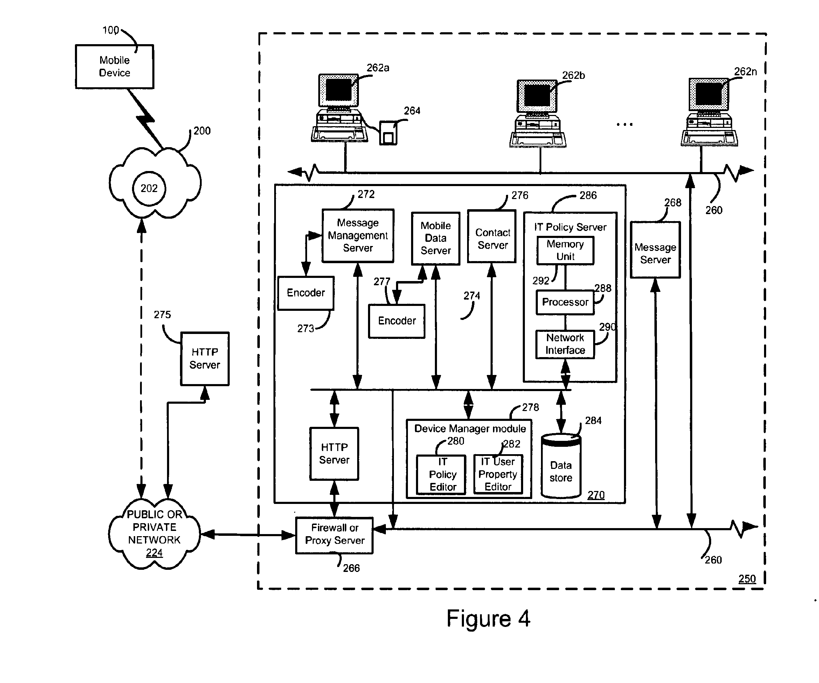

The mobile device 100 also includes a connect module 144, and an information technology (IT) policy module 146. The connect module 144 implements the communication protocols that are required for the mobile device 100 to communicate with the wireless infrastructure and any host system, such as an enterprise system, that the mobile device 100 is authorized to interface with. Examples of a wireless infrastructure and an enterprise system are given in Figures 3 and 4, which are described in more detail below.

The connect module 144 includes a set of APIs that can be integrated with the mobile device 100 to allow the mobile device 100 to use any number of services associated with the enterprise system. The connect module 144 allows the mobile device 100 to establish an end-to-end secure, authenticated communication pipe with the host system. A subset of applications for which access is provided by the connect module 144 can be used to pass IT policy commands from the host system to the mobile device 100. This can be done in a wireless or wired manner. These instructions can then be passed to the IT policy module 146 to modify the configuration of the device 100. Alternatively, in some cases, the IT policy update can also be done over a wired connection.

Other types of software applications can also be installed on the mobile device 100. These software applications can be third party applications, which are added after the manufacture of the mobile device 100. Examples of third party applications include games, calculators, utilities, etc.

The additional applications can be loaded onto the mobile device 100 through at least one of the wireless network 200, the auxiliary I/O subsystem 112, the data port 114, the short-range communications subsystem 122, or any other suitable device subsystem 124. This flexibility in application installation increases the functionality of the mobile device 100 and may provide enhanced on-device functions, communication-related functions, or both. For example, secure communication applications may enable electronic commerce functions and other such financial transactions to be performed using the mobile device 100.

The data port 114 enables a subscriber to set preferences through an external device or software application and extends the capabilities of the mobile device 100 by providing for information or software downloads to the mobile device 100 other than through a wireless communication network. The alternate download path may, for example, be used to load an encryption key onto the mobile device 100 through a direct and thus reliable and trusted connection to provide secure device communication.

The data port 114 can be any suitable port that enables data communication between the mobile device 100 and another computing device. The data port 114 can be a serial or a parallel port. In some instances, the data port 114 can be a USB port that includes data lines for data transfer and a supply line that can provide a charging current to charge the battery 130 of the mobile device 100.

The short-range communications subsystem 122 provides for communication between the mobile device 100 and different systems or devices, without the use of the wireless network 200. For example, the subsystem 122 may include an infrared device and associated circuits and components for short-range communication. Examples of short-range communication standards include standards developed by the Infrared Data Association (IrDA), Bluetooth, and the 802.11 family of standards developed by IEEE.

In use, a received signal such as a text message, an e-mail message, or web page download will be processed by the communication subsystem 104 and input to the main processor 102. The main processor 102 will then process the received signal for output to the display 110 or alternatively to the auxiliary I/O subsystem 112. A subscriber may also compose data items, such as e-mail messages, for example, using the keyboard 116 in conjunction with the display 110 and possibly the auxiliary I/O subsystem 112. The auxiliary subsystem 112 may include devices such as: a touch screen, mouse, track ball, infrared fingerprint detector, or a roller wheel with dynamic button pressing capability. The keyboard 116 is preferably an alphanumeric keyboard and/or telephone-type keypad. However, other types of keyboards may also be used. A composed item may be transmitted over the wireless network 200 through the communication subsystem 104.

For voice communications, the overall operation of the mobile device 100 is substantially similar, except that the received signals are output to the speaker 118, and signals for transmission are generated by the microphone 120. Alternative voice or audio I/O subsystems, such as a voice message recording subsystem, can also be implemented on the mobile device 100. Although voice or audio signal output is accomplished primarily through the speaker 118, the display 110 can also be used to provide additional information such as the identity of a calling party, duration of a voice call, or other voice call related information.

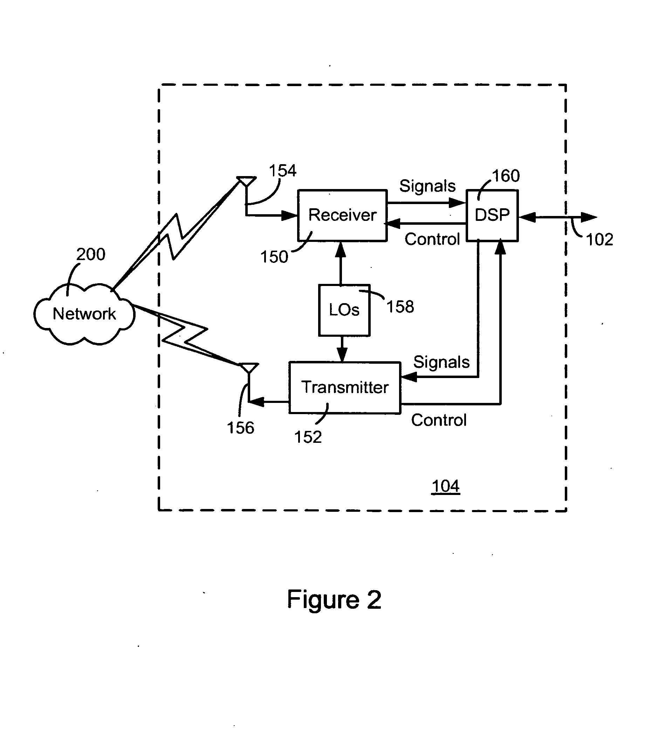

Referring now to Figure 2, an exemplary block diagram of the communication subsystem component 104 is shown. The communication subsystem 104 includes a receiver 150, a transmitter 152, as well as associated components such as one or more embedded or internal antenna elements 154 and 156, Local Oscillators (LOs) 158, and a processing module such as a Digital Signal Processor (DSP) 160. The particular design of the communication subsystem 104 is dependent upon the communication network 200 with which the mobile device 100 is intended to operate. Thus, it should be understood that the design illustrated in Figure 2 serves only as one example.

Signals received by the antenna 154 through the wireless network 200 are input to the receiver 150, which may perform such common receiver functions as signal amplification, frequency down conversion, filtering, channel selection, and analog-to-digital (A/D) conversion. A/D conversion of a received signal allows more complex communication functions such as demodulation and decoding to be performed in the DSP 160. In a similar manner, signals to be transmitted are processed, including modulation and encoding, by the DSP 160. These DSP-processed signals are input to the transmitter 152 for digital-to-analog (D/A) conversion, frequency up conversion, filtering, amplification and transmission over the wireless network 200 via the antenna 156. The DSP 160 not only processes communication signals, but also provides for receiver and transmitter control. For example, the gains applied to communication signals in the receiver 150 and the transmitter 152 may be adaptively controlled through automatic gain control algorithms implemented in the DSP 160.

The wireless link between the mobile device 100 and the wireless network 200 can contain one or more different channels, typically different RF channels, and associated protocols used between the mobile device 100 and the wireless network 200. An RF channel is a limited resource that should be conserved, typically due to limits in overall bandwidth and limited battery power of the mobile device 100.

When the mobile device 100 is fully operational, the transmitter 152 is typically keyed or turned on only when it is transmitting to the wireless network 200 and is otherwise turned off to conserve resources. Similarly, the receiver 150 is periodically turned off to conserve power until it is needed to receive signals or information (if at all) during designated time periods.

Referring now to Figure 3, a block diagram of an exemplary implementation of a node 202 of the wireless network 200 is shown. In practice, the wireless network 200 comprises one or more nodes 202. In conjunction with the connect module 144, the mobile device 100 can communicate with the node 202 within the wireless network 200. In the exemplary implementation of Figure 3, the node 202 is configured in accordance with General Packet Radio Service (GPRS) and Global Systems for Mobile (GSM) technologies. The node 202 includes a base station controller (BSC) 204 with an associated tower station 206, a Packet Control Unit (PCU) 208 added for GPRS support in GSM, a Mobile Switching Center (MSC) 210, a Home Location Register (HLR) 212, a Visitor Location Registry (VLR) 214, a Serving GPRS Support Node (SGSN) 216, a Gateway GPRS Support Node (GGSN) 218, and a Dynamic Host Configuration Protocol (DHCP) 220. This list of components is not meant to be an exhaustive list of the components of every node 202 within a GSM/GPRS network, but rather a list of components that are commonly used in communications through the network 200.

In a GSM network, the MSC 210 is coupled to the BSC 204 and to a landline network, such as a Public Switched Telephone Network (PSTN) 222 to satisfy circuit switched requirements. The connection through the PCU 208, the SGSN 216 and the GGSN 218 to a public or private network (Internet) 224 (also referred to herein generally as a shared network infrastructure) represents the data path for GPRS capable mobile devices. In a GSM network extended with GPRS capabilities, the BSC 204 also contains the Packet Control Unit (PCU) 208 that connects to the SGSN 216 to control segmentation, radio channel allocation and to satisfy packet switched requirements. To track the location of the mobile device 100 and availability for both circuit switched and packet switched management, the HLR 212 is shared between the MSC 210 and the SGSN 216. Access to the VLR 214 is controlled by the MSC 210.

The station 206 is a fixed transceiver station and together with the BSC 204 form fixed transceiver equipment. The fixed transceiver equipment provides wireless network coverage for a particular coverage area commonly referred to as a "cell". The fixed transceiver equipment transmits communication signals to and receives communication signals from mobile devices within its cell via the station 206. The fixed transceiver equipment normally performs such functions as modulation and possibly encoding and/or encryption of signals to be transmitted to the mobile device 100 in accordance with particular, usually predetermined, communication protocols and parameters, under control of its controller. The fixed transceiver equipment similarly demodulates and possibly decodes and decrypts, if necessary, any communication signals received from the mobile device 100 within its cell. Communication protocols and parameters may vary between different nodes. For example, one node may employ a different modulation scheme and operate at different frequencies than other nodes.

For all mobile devices 100 registered with a specific network, permanent configuration data such as a user profile is stored in the HLR 212. The HLR 212 also contains location information for each registered mobile device and can be queried to determine the current location of a mobile device. The MSC 210 is responsible for a group of location areas and stores the data of the mobile devices currently in its area of responsibility in the VLR 214. Further, the VLR 214 also contains information on mobile devices that are visiting other networks. The information in the VLR 214 includes part of the permanent mobile device data transmitted from the HLR 212 to the VLR 214 for faster access. By moving additional information from a remote HLR 212 node to the VLR 214, the amount of traffic between these nodes can be reduced so that voice and data services can be provided with faster response times and at the same time requiring less use of computing resources.

The SGSN 216 and the GGSN 218 are elements added for GPRS support; namely packet switched data support, within GSM. The SGSN 216 and the MSC 210 have similar responsibilities within the wireless network 200 by keeping track of the location of each mobile device 100. The SGSN 216 also performs security functions and access control for data traffic on the wireless network 200. The GGSN 218 provides internetworking connections with external packet switched networks and connects to one or more SGSN's 216 via an Internet Protocol (IP) backbone network operated within the network 200. During normal operations, a given mobile device 100 must perform a "GPRS Attach" to acquire an IP address and to access data services. This requirement is not present in circuit switched voice channels as Integrated Services Digital Network (ISDN) addresses are used for routing incoming and outgoing calls. Currently, all GPRS capable networks use private, dynamically assigned IP addresses, thus requiring the DHCP server 220 connected to the GGSN 218. There are many mechanisms for dynamic IP assignment, including using a combination of a Remote Authentication Dial-In User Service (RADIUS) server and a DHCP server. Once the GPRS Attach is complete, a logical connection is established from a mobile device 100, through the PCU 208, and the SGSN 216 to an Access Point Node (APN) within the GGSN 218. The APN represents a logical end of an IP tunnel that can either access direct Internet compatible services or private network connections. The APN also represents a security mechanism for the network 200, insofar as each mobile device 100 must be assigned to one or more APNs and mobile devices 100 cannot exchange data without first performing a GPRS Attach to an APN that it has been authorized to use. The APN may be considered to be similar to an Internet domain name such as "myconnection.wireless.com".

Once the GPRS Attach operation is complete, a tunnel is created and all traffic is exchanged within standard IP packets using any protocol that can be supported in IP packets. This includes tunneling methods such as IP over IP as in the case with some IPSecurity (IPsec) connections used with Virtual Private Networks (VPN). These tunnels are also referred to as Packet Data Protocol (PDP) Contexts and there are a limited number of these available in the network 200. To maximize use of the PDP Contexts, the network 200 will run an idle timer for each PDP Context to determine if there is a lack of activity. When a mobile device 100 is not using its PDP Context, the PDP Context can be de-allocated and the IP address returned to the IP address pool managed by the DHCP server 220.

Referring now to Figure 4, shown therein is a block diagram illustrating components of an exemplary configuration of a host system 250 that the mobile device 100 can communicate with in conjunction with the connect module 144. The host system 250 will typically be a corporate enterprise or other local area network (LAN), but may also be a home office computer or some other private system, for example, in variant implementations. In this example shown in Figure 4, the host system 250 is depicted as a LAN of an organization to which a user of the mobile device 100 belongs. Typically, a plurality of mobile devices can communicate wirelessly with the host system 250 through one or more nodes 202 of the wireless network 200.

The host system 250 comprises a number of network components connected to each other by a network 260. For instance, a user's desktop computer 262a with an accompanying cradle 264 for the user's mobile device 100 is situated on a LAN connection. The cradle 264 for the mobile device 100 can be coupled to the computer 262a by a serial or a Universal Serial Bus (USB) connection, for example. Other user computers 262b-262n are also situated on the network 260, and each may or may not be equipped with an accompanying cradle 264. The cradle 264 facilitates the loading of information (e.g. PIM data, private symmetric encryption keys to facilitate secure communications) from the user computer 262a to the mobile device 100, and may be particularly useful for bulk information updates often performed in initializing the mobile device 100 for use. The information downloaded to the mobile device 100 may include certificates used in the exchange of messages.

It will be understood by persons skilled in the art that the user computers 262a-262n will typically also be connected to other peripheral devices, such as printers, etc. which are not explicitly shown in Figure 4. Furthermore, only a subset of network components of the host system 250 are shown in Figure 4 for ease of exposition, and it will be understood by persons skilled in the art that the host system 250 will comprise additional components that are not explicitly shown in Figure 4 for this exemplary configuration. More generally, the host system 250 may represent a smaller part of a larger network (not shown) of the organization, and may comprise different components and/or be arranged in different topologies than that shown in the exemplary embodiment of Figure 4.

To facilitate the operation of the mobile device 100 and the wireless communication of messages and message-related data between the mobile device 100 and components of the host system 250, a number of wireless communication support components 270 can be provided. In some implementations, the wireless communication support components 270 can include a message management server 272, a mobile data server (MDS) 274, a web server, such as Hypertext Transfer Protocol (HTTP) server 275, a contact server 276, and a device manager module 278. HTTP servers can also be located outside the enterprise system, as indicated by the HTTP server 275 attached to the network 224. The device manager module 278 includes an IT Policy editor 280 and an IT user property editor 282, as well as other software components for allowing an IT administrator to configure the mobile devices 100. In an alternative embodiment, there may be one editor that provides the functionality of both the IT policy editor 280 and the IT user property editor 282. The support components 270 also include a data store 284, and an IT policy server 286. The IT policy server 286 includes a processor 288, a network interface 290 and a memory unit 292. The processor 288 controls the operation of the IT policy server 286 and executes functions related to the standardized IT policy as described below. The network interface 290 allows the IT policy server 286 to communicate with the various components of the host system 250 and the mobile devices 100. The memory unit 292 can store functions used in implementing the IT policy as well as related data. Those skilled in the art know how to implement these various components. Other components may also be included as is well known to those skilled in the art. Further, in some implementations, the data store 284 can be part of any one of the servers.

In this exemplary embodiment, the mobile device 100 communicates with the host system 250 through node 202 of the wireless network 200 and a shared network infrastructure 224 such as a service provider network or the public Internet. Access to the host system 250 may be provided through one or more routers (not shown), and computing devices of the host system 250 may operate from behind a firewall or proxy server 266. The proxy server 266 provides a secure node and a wireless internet gateway for the host system 250. The proxy server 266 intelligently routes data to the correct destination server within the host system 250.

In some implementations, the host system 250 can include a wireless VPN router (not shown) to facilitate data exchange between the host system 250 and the mobile device 100. The wireless VPN router allows a VPN connection to be established directly through a specific wireless network to the mobile device 100. The wireless VPN router can be used with the Internet Protocol (IP) Version 6 (IPV6) and IP-based wireless networks. This protocol can provide enough IP addresses so that each mobile device has a dedicated IP address, making it possible to push information to a mobile device at any time. An advantage of using a wireless VPN router is that it can be an off-the-shelf VPN component, and does not require a separate wireless gateway and separate wireless infrastructure. A VPN connection can preferably be a Transmission Control Protocol (TCP)/IP or User Datagram Protocol (UDP)/IP connection for delivering the messages directly to the mobile device 100 in this alternative implementation.

Messages intended for a user of the mobile device 100 are initially received by a message server 268 of the host system 250. Such messages may originate from any number of sources. For instance, a message may have been sent by a sender from the computer 262b within the host system 250, from a different mobile device (not shown) connected to the wireless network 200 or a different wireless network, or from a different computing device, or other device capable of sending messages, via the shared network infrastructure 224, possibly through an application service provider (ASP) or Internet service provider (ISP), for example.

The message server 268 typically acts as the primary interface for the exchange of messages, particularly e-mail messages, within the organization and over the shared network infrastructure 224. Each user in the organization that has been set up to send and receive messages is typically associated with a user account managed by the message server 268. Some exemplary implementations of the message server 268 include a Microsoft Exchange™ server, a Lotus Domino™server, a Novell Groupwise™server, or another suitable mail server installed in a corporate environment. In some implementations, the host system 250 may comprise multiple message servers 268. The message server 268 may also be adapted to provide additional functions beyond message management, including the management of data associated with calendars and task lists, for example.

When messages are received by the message server 268, they are typically stored in a data store associated with the message server 268. In at least some embodiments, the data store may be a separate hardware unit, such as data store 284, that the message server 268 communicates with. Messages can be subsequently retrieved and delivered to users by accessing the message server 268. For instance, an e-mail client application operating on a user's computer 262a may request the e-mail messages associated with that user's account stored on the data store associated with the message server 268. These messages are then retrieved from the data store and stored locally on the computer 262a. The data store associated with the message server 268 can store copies of each message that is locally stored on the mobile device 100. Alternatively, the data store associated with the message server 268 can store all of the messages for the user of the mobile device 100 and only a smaller number of messages can be stored on the mobile device 100 to conserve memory. For instance, the most recent messages (i.e. those received in the past two to three months for example) can be stored on the mobile device 100.

When operating the mobile device 100, the user may wish to have e-mail messages retrieved for delivery to the mobile device 100. The message application 138 operating on the mobile device 100 may also request messages associated with the user's account from the message server 268. The message application 138 may be configured (either by the user or by an administrator, possibly in accordance with an organization's IT policy) to make this request at the direction of the user, at some pre-defined time interval, or upon the occurrence of some pre-defined event. In some implementations, the mobile device 100 is assigned its own e-mail address, and messages addressed specifically to the mobile device 100 are automatically redirected to the mobile device 100 as they are received by the message server 268.

The message management server 272 can be used to specifically provide support for the management of messages, such as e-mail messages, that are to be handled by mobile devices. Generally, while messages are still stored on the message server 268, the message management server 272 can be used to control when, if, and how messages are sent to the mobile device 100. The message management server 272 also facilitates the handling of messages composed on the mobile device 100, which are sent to the message server 268 for subsequent delivery.

For example, the message management server 272 may monitor the user's "mailbox" (e.g. the message store associated with the user's account on the message server 268) for new e-mail messages, and apply user-definable filters to new messages to determine if and how the messages are relayed to the user's mobile device 100. The message management server 272 may also, through an encoder 273, compress messages, using any suitable compression technology (e.g. YK compression, and other known techniques) and encrypt messages (e.g. using an encryption technique such as Data Encryption Standard (DES), Triple DES, or Advanced Encryption Standard (AES)), and push them to the mobile device 100 via the shared network infrastructure 224 and the wireless network 200. The message management server 272 may also receive messages composed on the mobile device 100 (e.g. encrypted using Triple DES), decrypt and decompress the composed messages, re-format the composed messages if desired so that they will appear to have originated from the user's computer 262a, and re-route the composed messages to the message server 268 for delivery.

Certain properties or restrictions associated with messages that are to be sent from and/or received by the mobile device 100 can be defined (e.g. by an administrator in accordance with IT policy) and enforced by the message management server 272. These may include whether the mobile device 100 may receive encrypted and/or signed messages, minimum encryption key sizes, whether outgoing messages must be encrypted and/or signed, and whether copies of all secure messages sent from the mobile device 100 are to be sent to a pre-defined copy address, for example.

The message management server 272 may also be adapted to provide other control functions, such as only pushing certain message information or pre-defined portions (e.g. "blocks") of a message stored on the message server 268 to the mobile device 100. For example, in some cases, when a message is initially retrieved by the mobile device 100 from the message server 268, the message management server 272 may push only the first part of a message to the mobile device 100, with the part being of a pre-defined size (e.g. 2 KB). The user can then request that more of the message be delivered in similar-sized blocks by the message management server 272 to the mobile device 100, possibly up to a maximum pre-defined message size. Accordingly, the message management server 272 facilitates better control over the type of data and the amount of data that is communicated to the mobile device 100, and can help to minimize potential waste of bandwidth or other resources.

The MDS 274 encompasses any other server that stores information that is relevant to the corporation. The mobile data server 274 may include, but is not limited to, databases, online data document repositories, customer relationship management (CRM) systems, or enterprise resource planning (ERP) applications. The MDS 274 can also connect to the Internet or other public network, through HTTP server 275 or other suitable web server such as an File Transfer Protocol (FTP) server, to retrieve HTTP webpages and other data. Requests for webpages are typically routed through MDS 274 and then to HTTP server 275, through suitable firewalls and other protective mechanisms. The web server then retrieves the webpage over the Internet, and returns it to MDS 274. As described above in relation to message management server 272, MDS 274 is typically provided, or associated, with an encoder 277 that permits retrieved data, such as retrieved webpages, to be compressed, using any suitable compression technology (e.g. YK compression, and other known techniques), and encrypted (e.g. using an encryption technique such as DES, Triple DES, or AES), and then pushed to the mobile device 100 via the shared network infrastructure 224 and the wireless network 200.

The contact server 276 can provide information for a list of contacts for the user in a similar fashion as the address book on the mobile device 100. Accordingly, for a given contact, the contact server 276 can include the name, phone number, work address and e-mail address of the contact, among other information. The contact server 276 can also provide a global address list that contains the contact information for all of the contacts associated with the host system 250.

It will be understood by persons skilled in the art that the message management server 272, the MDS 274, the HTTP server 275, the contact server 276, the device manager module 278, the data store 284 and the IT policy server 286 do not need to be implemented on separate physical servers within the host system 250. For example, some or all of the functions associated with the message management server 272 may be integrated with the message server 268, or some other server in the host system 250. Alternatively, the host system 250 may comprise multiple message management servers 272, particularly in variant implementations where a large number of mobile devices need to be supported.

The device manager module 278 provides an IT administrator with a graphical user interface with which the IT administrator interacts to configure various settings for the mobile devices 100. As mentioned, the IT administrator can use IT policy rules to define behaviors of certain applications on the mobile device 100 that are permitted such as phone, web browser or Instant Messenger use. The IT policy rules can also be used to set specific values for configuration settings that an organization requires on the mobile devices 100 such as auto signature text, WLAN/VolP/VPN configuration, security requirements (e.g. encryption algorithms, password rules, etc.), specifying themes or applications that are allowed to run on the mobile device 100, and the like.

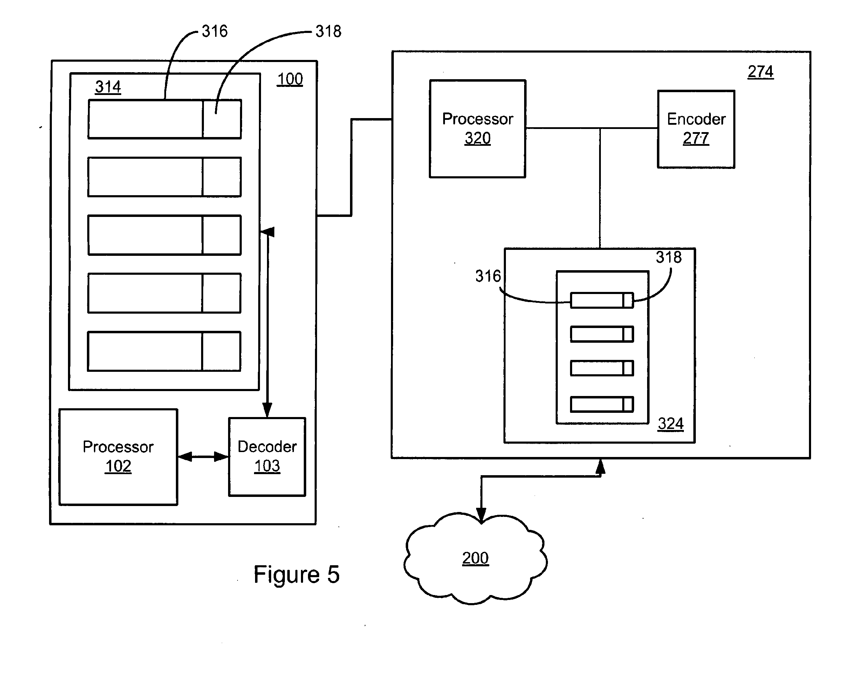

Referring to Figure 5, a schematic view of the mobile device 100 and a server, such as MDS 274, the message management server 272 or any other server involved in the transfer of information or data to and from the mobile device 100 is shown. The mobile device 100 and the server can be seen as communicating parties for a method of interactive compression.

The mobile device 100 includes a main processor 102, a decoder 103, and a device side information database 314, which can also be described as a cache, store, or repository. The device side information database 314 stores units of side information 316. Side information is information that is used to describe parameters associated with data such as emails or web pages. Side information is a priori information that is known to both the encoder and decoder. It can be correlated with the data that is being compressed, such as emails in the same thread or web pages from the same site and is used to improve compression. In order to be able to decode data compressed using side information, the decoder uses the same side information used by the encoder. This side information can be represented in different forms including but not limited to compression state information 318. The compression state information 318 includes parameters, such as grammar, which consists of production rules and/or frequency statistics, of previously completed compressions. As previously noted, the compression state information from previously completed compressions can improve compression of subsequent data having similar properties and/or content. The server includes a processor 320, and has access to an encoder, such as encoder 277, and a server side information database 324. The encoder 277 and the server side information database 324 can be integral with the server, or separate therefrom. The server side information database 324 generally contains side information, including compression state information, associated with the mobile device 100. The server is connected to the network 200 so that it may retrieve data from other servers connected to the network, such as HTTP server 275, as is described in more detail below. The side information stored in the respective side information databases 314 and 324 can be organized in any suitable manner for searching and retrieval by the device side decoder 103 and the server side encoder 277, respectively.

Interactive compression according to the present disclosure can be generally understood by reference to an exemplary transmission to the mobile device 100, such as an HTTP webpage.

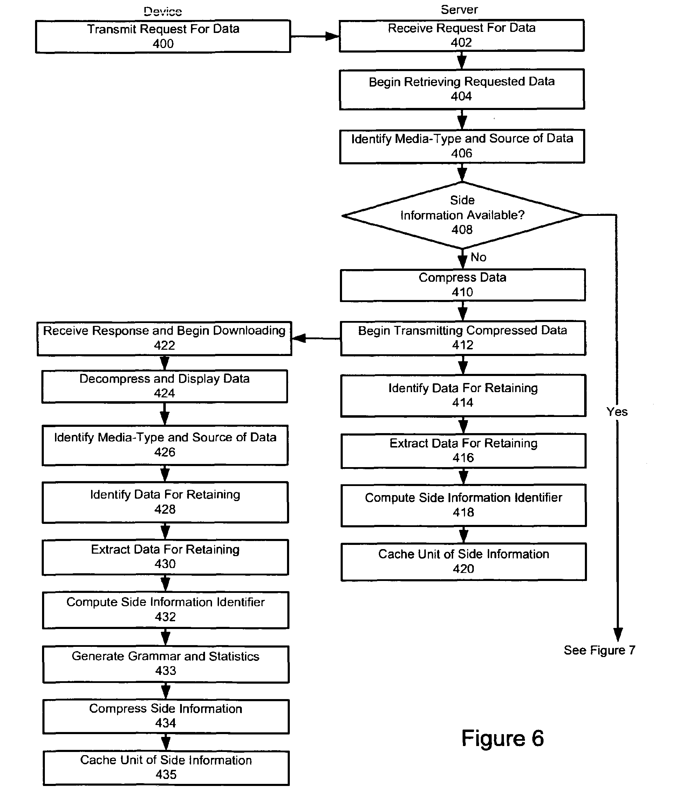

Figure 6 is a flowchart of a method of interactive compression for communication between the server and the mobile device 100. The mobile device 100 identifies data to request, such as a webpage identified by a Uniform Resource Locator (URL), and a request for the identified data is transmitted from the mobile device 100 to the server along with an indication that the mobile device 100 is YK-enabled (step 400). The request therefore includes an indication that the decoder 103 can accept content compressed using side information. In the example of the HTTP webpage, a request header is sent from the decoder 103 to the encoder 277, including the requested URL, and the indication that the decoder 103 can accept content compressed using side information. An exemplary request header can include, for example:
GET/HTTP/1.1
Host: www.example.com
Accept-Encoding: gzip, side-info-impl
Connection: keep-alive
In this example, the "Accept-Encoding" field in the request header indicates to the encoder that the decoder is able to accept content compressed using side information. The mobile device 100 then awaits receipt of the requested data transmitted from the server.

The request sent from the mobile device 100 is received at the server (step 402) and the server identifies the requested data and begins retrieving the identified requested data (step 404). The requested data can be located within the server or can be accessible through a remote server, such as HTTP server 275, over the network 200. Continuing with the above example of requesting an HTTP webpage, the requested data is identified using the URL provided in the request header and the server begins retrieving the requested data from the webpage.

The server then determines the media-type as well as the data source, for determining if an appropriate unit of side information is available for compressing and decompressing the requested data (step 406). Thus, the identity of media-type of the data, such as HTML, XML, RTF, etc., as well as the data source is determined and the server searches the server side information database 324 to determine if a suitable unit of side information, based on the media-type and data source, is associated with the mobile device 100 (step 408). The server thereby determines if a suitable unit of side information has been previously stored for the mobile device 100 for the identified media-type and data source and if not, the data is compressed without the use of side information (step 410). According to the present embodiment, the first time data of a particular media-type and data source is requested, no side information exists in association with the mobile device 100 and therefore the data retrieved is compressed without the benefit of the use of side information.

The server then transmits a response to the mobile device 100. The compression method used is identified in the response sent to the mobile device 100 (step 412) and the requested data is transmitted. Rather than waiting for all of the requested data to be retrieved, the server can begin streaming the response to the mobile device 100 shortly after beginning retrieval of the requested data (when the requested data begins to arrive). It will be appreciated that there may be a minimum amount that the server retrieves before the side information is selected and before starting to transmit the data. For example, the server may require receipt of an entire HTTP header prior to determining if suitable side information is stored for the mobile device 100. Alternatively, the server may wait to receive some minimum amount of data for inspection to determine the media-type of the response such as plain text, HTML, XML, CSS, JavaScript, an image format...etc. It will now be appreciated that it is not necessary that all the data be retrieved at the server prior to beginning compression and transmission of data.

Data for retaining is then determined (step 414). In the present embodiment, constituents of the data are determined to identify the displayable data and the remaining data, including structure and formatting information for rendering data, based on the media-type of the data. The remaining data (data for retaining) including the structure and formatting is then extracted for use as the unit of side information for compressing data of similar media-type and data source in response to future requests (step 416). In one example, HTML data can be requested by the mobile device 100 and retrieved by the server. An exemplary HTML fragment is shown below including displayable data and the remaining data including the structure and formatting.
<HTML>
<BODY>
Exemplary displayable HTML data
</BODY>
</HTML>

In the above example the "Exemplary displayable HTML data" is identified as displayable data at step 414 and the remaining constituents include the structure and formatting as referred to above. The structure and formatting are extracted for use as the side information. Thus, the remaining constituents are extracted from the exemplary HTML fragment shown above, resulting in the exemplary constituents shown below.
<HTML>
<BODY>
</BODY>
</HTML>
Any CSS-style (Cascading Style Sheets) descriptions or JavaScript contained in the document is also preserved for use in the side information.

Next, a unique identifier is computed for the extracted data including the structure and formatting, referred to now as the unit of side information (step 418). The unique identifier is employed to ensure that the decoder 103 of the mobile device 100 uses the same unit of side information for decompression as the encoder 277 uses for compression on the server side. The unique identifier can be any identifier that uniquely identifies the unit of side information, such as a hash of the bytes of side information along with other information such as the length of the side information in bytes. Thus, the unique identifier is computed by performing a hashing operation such as MD5, MD4, SHA-1, CRC-32, CRC-16 or any other suitable hashing operation that provides a good hash distribution and the length of the side information, in bytes, is included. To ensure the unique identifier is truly unique, other information can be incorporated into the unique identifier. For example, a portion or form of the URL can be included in the unique identifier for an HTTP based application. Other information can also be included to form the unique identifier such as a modification date and time of the unit of side information, a version number and/or a randomly generated number.

The unit of side information is cached (step 420), storing the unit of side information in the server side information database 324 in association with the unique identifier for use in compressing data of the same media-type and data source in response to future requests from the mobile device 100. The server side information database 314 can store more than one unit of side information as units of side information apply to like data formats and data sources.

The response including the identity of the compression method used is received at the mobile device 100 (step 422) and it is determined that no side information was used to compress the data. Thus, the decoder 103 decompresses the received data and renders the data on the display 110 (step 424). The mobile device 100 determines the media-type of the requested data (step 426). Thus, the identity of the media-type of the data, such as HTML, XML, RTF, etc., is determined and the data for retaining is determined based on the media-type of the data (step 428). In the present embodiment, constituents of the data are determined to identify the displayable data and the remaining data, including the structure and formatting for rendering, based on the identity of the media-type of the data. The remaining data (data for retaining) including the structure and formatting is extracted from the data for use as the unit of side information for decompressing data of similar media-type received in response to future requests (step 430).

Next, the unique identifier is computed for the extracted data, referred to now as the unit of side information (step 432). As indicated above, the unique identifier is employed to ensure that the decoder 103 of the mobile device 100 uses the same unit of side information for decompression as the encoder 277 uses for compression on the server side. The unique identifier can be any identifier that uniquely identifies the unit of side information, such as a hash of the bytes of side information along with other information such as the length of the side information in bytes. Thus, the unique identifier is computed using the identical operation at the mobile device 100 as that at the server, described above with reference to step 418. Thus, the same hashing operation such as MD5, MD4, SHA-1, CRC-32, CRC-16 or any other suitable hashing operation is performed at the mobile device 100 as that performed by the server and the same information such as the length of the side information, in bytes, is included to ensure the unique identifier is truly unique.

The reduced data is used to build the grammar and collect frequency counts for compression of data (step 433) and the side information including the grammar and frequency counts is compressed using YK compression without the use of any side information (step 434). It will be appreciated that compression using YK compression may be optional. In the present embodiment, the reduced data including the grammar and frequency counts is compressed to reduce the data for storage on the mobile device. Thus, further units of side information can be stored in the same storage space.

The compressed data is cached (step 435), storing the unit of side information including the grammar and frequency counts in the device side information database 314 in association with the unique identifier for use in decompressing data of similar media-type received in response to future requests. The device side information database 314 can store more than one unit of side information as units of side information only apply to like data formats. Thus, the unit of side information is reduced by removing displayable data at both the mobile device 100 and the server.

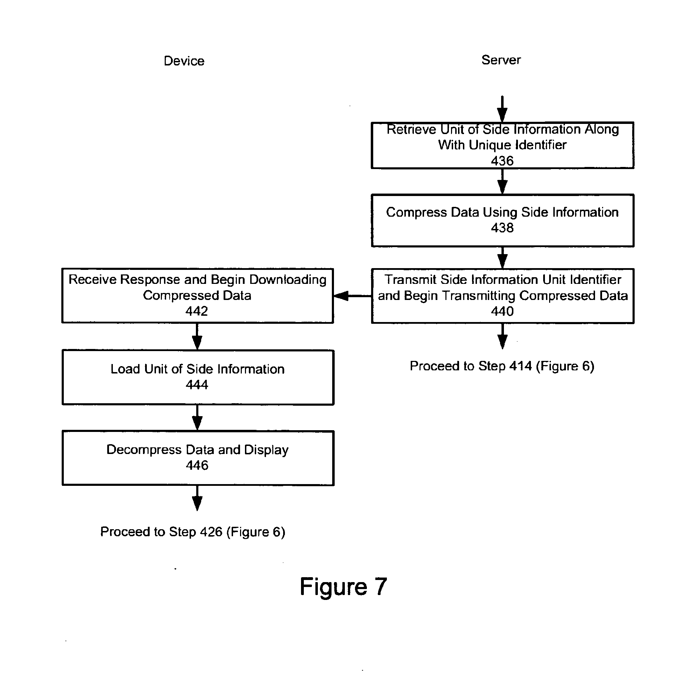

Returning to step 408, the server searches the server side information database 324 to determine if a suitable unit of side information, based on media-type and data source, is associated with the mobile device 100. The server thereby determines if a suitable unit of side information has been previously stored for the mobile device 100 for the media-type and the data source and if so, the unit of side information is retrieved along with the unique identifier, as shown in Figure 7 (step 436). According to the present embodiment, the first time data of a particular media-type and data source is requested, no side information exists in association with the mobile device 100 and therefore the data retrieved is compressed without the benefit of the use of side information. The second time data of a particular media-type and data source is requested, the server and the mobile device 100 have a unit of side information stored in association with a unique identifier in their respective side information databases 324, 314.

After retrieving the unit side information based on the media-type and data source, along with the unique identifier of the side information, the server builds the grammar and collects frequency counts and compresses the data using the side information, grammar and frequency counts (step 438). The server then transmits a response to the mobile device 100. The compression method used is identified in the response sent to the mobile device 100 along with the identifier of the unit of side information and the requested data is transmitted (step 440). As described above, rather than waiting for all of the requested data to be retrieved, the server can begin streaming the response to the mobile device 100 shortly after beginning retrieval of the requested data (when the requested data begins to arrive). It will be appreciated that there may be a minimum amount that the server retrieves before the side information is selected and before starting to transmit the data. For example, the server may require receipt of the entire HTTP header prior to selection of the side information for compression. It will now be appreciated that it is not necessary that all the data be retrieved at the server prior to retrieving the unit of side information and prior to beginning compression and transmission. After beginning transmission of the identifier of the unit of side information and the requested data, the process returns to step 414 and, as described above with reference to Figure 6, and the data for retaining is determined (step 428). In the present embodiment, the constituents of the data retrieved are then determined including the displayable content and the remaining data including structure and formatting based on the identity of the media-type of the data. The process proceeds through the remaining steps 416 to 420 and the new unit of side information created from the data is cached, storing the unit of side information in the server side information database 324 in association with the unique identifier for use in compressing data of the same media-type and data source in response to future requests from the mobile device 100. Many units of side information can therefore be stored in the server side information database 324 and the side information cache size can be managed using any suitable technique.

It will be appreciated that if the data sent to the mobile device 100 at step 440 is identical to data previously sent to the mobile device 100, the unit of side information cached at step 420 will be the same as a previously cached unit of side information and will have the same side information identifier. Thus, only a single cache entry is stored in the server side information database 324 for the data as the unit of side information overwrites the previous unit of side information stored in association with the side information identifier. It will also be appreciated that data such as an HTML page that differs in displayable data from data previously sent to the mobile device 100 may result in identical side information and therefore an identical side information identifier after reducing the data. Again, only a single cache entry is stored in the server side information database 324 in association with the side information identifier.

In the embodiment described above with reference to Figure 6, data is sent to the mobile device in response to receipt of a request for data. It will be appreciated that data such as email data can be sent to the mobile device 100 in a "push" operation, and therefore, a unit of side information is selected and the data is compressed and sent automatically without receipt of a request for data at the server.

Continuing still with the above example of requesting an HTTP webpage, an HTTP response header is sent from the encoder 277 to the decoder 103. The HTTP response header indicates the compression method used in compressing the data at the encoder 277 as well as the unique identifier of the unit of side information used. The following HTTP response header is provided for exemplary purposes only.
HTTP/1.1 200 OK
Connection: close
Content-Type: text/html
Content-Encoding: side-info-impl
X-Side-Info-Identifier: OxE323FA21
In this example, the unit of side information used is identified using the unique identifier OxE323FA21.

The response including the unique identifier of the unit of side information is received at the mobile device 100 (step 442) and the unit of side information resident on the mobile device 100, in the side information database 314, is identified using the unique identifier and the decoder 103 loads the unit of side information for use in decompressing the received data (step 444). The received data is then decompressed using the unit of side information and rendered on the display 110 (step 446).

After all the data is received and decompressed, the process returns to step 426 and, as described above with reference to Figure 6, the mobile device 100 identifies the media-type and source of the requested data. The process proceeds through the remaining steps 428 to 435 and the new unit of side information created from the data including the grammar and frequency counts is compressed and cached, storing the unit of side information in the device side information database 314 in association with the unique identifier for use in decompressing data of the same media-type and data source. Many units of side information can therefore be stored in the device side information database 314 and the side information cache size can be managed using any suitable technique..

It will be appreciated that if the data received at the mobile device 100 at step 442 is identical to data previously received at the mobile device 100, the unit of side information cached at step 435 will be the same as a previously cached unit of side information and will have the same side information identifier. Thus, only a single cache entry is stored in the device side information database 314 for the data as the unit of side information overwrites the previous unit of side information stored in association with the side information identifier. It will also be appreciated that data such as an HTML page that differs in content from data previously received at the mobile device 100 may result in identical side information and therefore an identical side information identifier after reducing the data. Again, only a single cache entry is stored in the device side information database 314 in association with the side information identifier.

As described, the unit of side information is identified at the mobile device 100 and loaded into the decoder based on the unique identifier. If no matching unique identifier is found in the device side information database 314, a request for side information can be sent to the server, for example. A matching unique identifier and associated unit of side information may not be found if, for example, an error occurred during reducing the side information by removing the content. Alternatively, when messages are pushed to the mobile device, data may be re-ordered over the network and therefore a pushed mail message may reference a unit of side information that has not yet been received at the mobile device 100. It is possible for several messages to be received in a queue at the mobile device 100 prior to receipt of the unit of side information for decompressing the messages, for example. Further, certain conditions may result in the loss of a unit or units of side information. For example, removal of the battery 130, wiping of memory or certain other conditions may result in loss of units of side information stored in the device side information database 314.

Continued reference is made to Figures 6 and 7 to describe another embodiment. In the present embodiment, the mobile device 100 determines the unit of side information for use in compression and decompression, rather than the server. The mobile device 100 identifies data to request, such as a webpage identified by a Uniform Resource Locator (URL), and the request for the identified data is transmitted from the mobile device 100 to the server along with an indication that the mobile device 100 is YK-enabled and a unique identifier of the unit of side information selected by the mobile device 100 based on the data being requested (step 400). The request therefore includes an indication that the decoder 103 can accept content compressed using side information and an indication of the unit of side information to use for compression. In the example of the HTTP webpage, a request header is sent from the decoder 103 to the encoder 277, including the requested URL, the indication that the decoder 103 can accept content compressed using side information, and the unique identifier of the unit of side information. An exemplary request header according to the present embodiment can include, for example:
GET/HTTP/1.1
Host: www.example.com
Accept-Encoding: gzip, side-info-impl
X-Use-Sidelnfo:0x12345678
In this example, the "Accept-Encoding" field in the request header indicates to the encoder that the decoder is able to accept content compressed using side information and the X-Use-Sidelnfo:0x12345678 indicates the unit of side information to use for compression. The mobile device 100 then awaits receipt of the requested data transmitted from the server.

The request sent from the mobile device 100 is received at the server (step 402) and the server identifies the requested data and begins retrieving the identified requested data (step 404). The server then determines the media-type as well as the data source (step 406) and determines if the unit of side information is available for compressing the requested data (step 408). In the present example, the server determines if the unit of side information, as identified in the request from the mobile device 100, is available. Thus, the server searches the server side information database 324 for the unit of side information, identified by the unique identifier of the unit of side information.

If the side information identified by the mobile device 100 in the request is not resident in the server side information database 324, the data is compressed without the use of side information (step 410). The server then transmits a response to the mobile device 100. The compression method used is identified in the response and an indication that no side information was used is provided (step 412). The requested data is transmitted. As described above, the server can begin streaming the response to the mobile device 100 shortly after beginning retrieval of the requested data (when the requested data begins to arrive). There may be a minimum amount that the server retrieves before starting to compress and then transmit the data.

The data for retaining is then determined (step 414). In the present embodiment, the constituents of the data are determined to identify the displayable data as well as the remaining data including the structure and formatting of the data based on the identity of the media-type of the data. The remaining data including the structure and formatting is then extracted (step 416). Next, a unique identifier is computed for the remaining data, referred to now as the unit of side information (step 418). The unique identifier is employed to ensure that the decoder 103 of the mobile device 100 uses the same unit of side information for decompression as the encoder 277 uses for compression on the server side. As previously described, the unique identifier can be any identifier that uniquely identifies the unit of side information, such as a hash of the bytes of side information along with other information such as the length of the side information in bytes. The unit of side information is cached (step 420), storing the unit of side information in the server side information database 324 in association with the unique identifier for use in compressing data of the same media-type and data source in response to future requests from the mobile device 100. The server side information database 314 can store more than one unit of side information as units of side information apply to like data formats and data sources.

The response including the identity of the compression method used is received at the mobile device 100 (step 422) and it is determined that no side information was used to compress the data. Thus, the decoder 103 decompresses the received data and renders the data on the display 110 (step 424). The mobile device 100 identifies the media-type (step 426). The data for retaining is then determined (step 428). In the present embodiment, the constituents of the data are determined to identify the displayable data and the remaining data including the structure and formatting for rendering based on the identity of the media-type of the data. The data for retaining including the structure and formatting is again extracted for use as the unit of side information for decompressing data of similar media-type received in response to future requests (step 430). Next, the unique identifier is computed for the remaining data (step 432). The reduced data is used to build the grammar and collect frequency counts for compression of data (step 433) and the remaining data including the grammar and frequency counts is compressed using YK compression without the use of any side information (step 434). The compressed data including the grammar and frequency counts is cached (step 435) by storing the data in the device side information database 314 in association with the unique identifier. Thus, the unit of side information is reduced, by removing the displayable data, and stored at both the mobile device 100 and the server.

Returning to step 408, the server searches the server side information database 324 for the unit of side information identified by the unique identifier of the unit of side information provided in the request from the mobile device 100. Thus, the server determines if the unit of side information is resident in the server-side database 324 and, if so, the unit of side information is retrieved along with the unique identifier, as shown in Figure 7 (step 436). After retrieving the unit side information associated with the unique identifier of the side information, the server builds the grammar and collects frequency counts and then compresses the data (step 438). The server then transmits a response to the mobile device 100. The compression method used is identified in the response sent to the mobile device 100 along with the identifier of the unit of side information and the requested data is transmitted (step 440). In one example, an HTTP response header is received. An exemplary HTTP response header can include, for example:
HTTP/1.1 200 OK
Connection: keep-alive
Content-Encoding: side-info-impl
X-Sidelnfo- Identifier:0x12345678

As described above, rather than waiting for all of the requested data to be retrieved, the server can begin compressing and streaming the response to the mobile device 100 shortly after beginning retrieval of the requested data (when the requested data begins to arrive). Again, there may be a minimum amount that the server retrieves before compression and transmission. After beginning transmission, the process returns to step 414 and, as described above with reference to Figure 6, the data for retaining is determined. The process proceeds through the remaining steps 416 to 420 and the new unit of side information created from the data is cached, storing the unit of side information in the server side information database 324 in association with the unique identifier for use in compressing data of the same media-type and data source in response to future requests from the mobile device 100. Many units of side information can therefore be stored in the server side information database 324 and the side information cache size can be managed using any suitable technique.

It will be appreciated that if the data sent to the mobile device 100 at step 440 is identical to data previously sent to the mobile device 100, the unit of side information cached at step 420 will be the same as a previously cached unit of side information and will have the same side information identifier. Thus, only a single cache entry is stored in the server side information database 324 for the data as the unit of side information overwrites the previous unit of side information stored in association with the side information identifier. It will also be appreciated that data such as an HTML page that differs in displayable data from data previously sent to the mobile device 100 may result in identical side information and therefore an identical side information identifier after reducing the data. Again, only a single cache entry is stored in the server side information database 324 in association with the side information identifier.

The response including the unique identifier of the unit of side information is received at the mobile device 100 (step 442) and the decoder 103 loads the unit of side information for use in decompressing the received data (step 444). The received data is then decompressed using the unit of side information and rendered on the display 110 (step 446). After all the data is received and decompressed, the process returns to step 426 and, as described above with reference to Figure 6, the mobile device 100 identifies the media-type and source of the requested data. The process proceeds through the remaining steps 428 to 435 and the compressed data including the grammar and frequency counts is cached, storing the unit of side information including the grammar and frequency counts in the device side information database 314 in association with the unique identifier for use in decompressing data of the same media-type and data source. Many units of side information can therefore be stored in the device side information database 314 and the side information cache size can be managed using any suitable technique..

It will again be appreciated that if the data received at the mobile device 100 at step 442 is identical to data previously received at the mobile device 100, the unit of side information cached at step 435 will be the same as a previously cached unit of side information and will have the same side information identifier. Thus, only a single cache entry is stored in the device side information database 314 for the data as the unit of side information overwrites the previous unit of side information stored in association with the side information identifier. It will also be appreciated that data such as an HTML page that differs in content from data previously received at the mobile device 100 may result in identical side information and therefore an identical side information identifier after reducing the data. Again, only a single cache entry is stored in the device side information database 314 in association with the side information identifier.

According to the present embodiment, the first time data of a particular media-type and data source is requested, no side information exists at the device side information database 314 and therefore the request is sent without any unique identifier of a unit of side information and it is determined at step 408 that no side information is available. Thus, data retrieved is compressed without the benefit of the use of side information. The second time data of a particular media-type and data source is requested, the server and the mobile device 100 have a unit of side information stored in association with a unique identifier in their respective side information databases 324, 314 and the unique identifier of the unit of side information is included in the request from the mobile device 100.

In the embodiments described above with reference to Figures 6 and 7, data is sent to the mobile device in response to receipt of a request for data. It will be appreciated that data such as email data can be sent to the mobile device 100 in a "push" operation, and therefore, a unit of side information can be selected and the data compressed and sent automatically without receipt of a request for data transmission. Alternatively, the server can communicate with the mobile device 100 that data is to be transmitted and await a request including a unique identifier of a unit of side information to be used in compression.

Rather than the data being reduced at both the mobile device 100 and the server, the server can, instead, reduce the data to form the unit of side information and then send the unit of side information to the mobile device 100. Further, the unique identifier can be sent to the mobile device 100 for storage of the unit of side information in association with the unique identifier at the device side information database 314. Thus, after computing the side information identifier at step 418, for example, the unit of side information and the side information identifier can be sent to the mobile device 100 for storage, thereby reducing the calculations performed by the processor at the mobile device 100. Alternatively, it is possible that the mobile device 100 can reduce the side information and send the reduced side information to the server for storage.

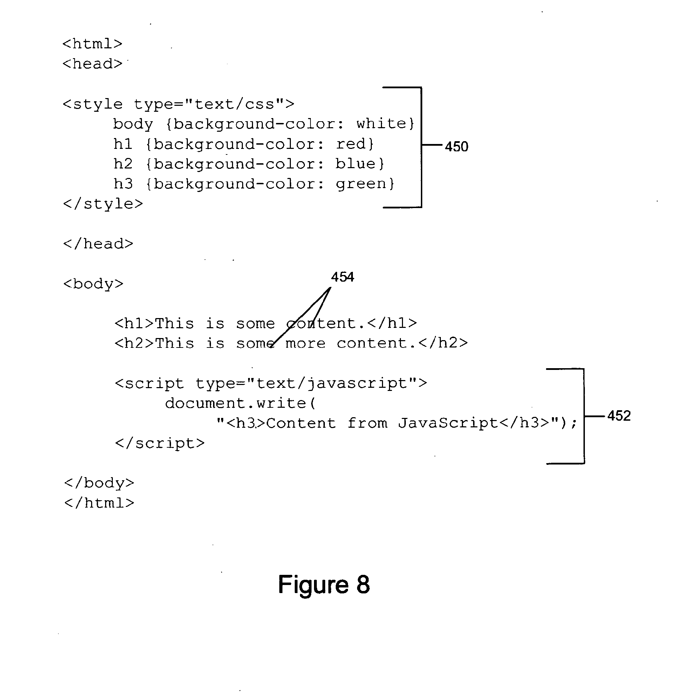

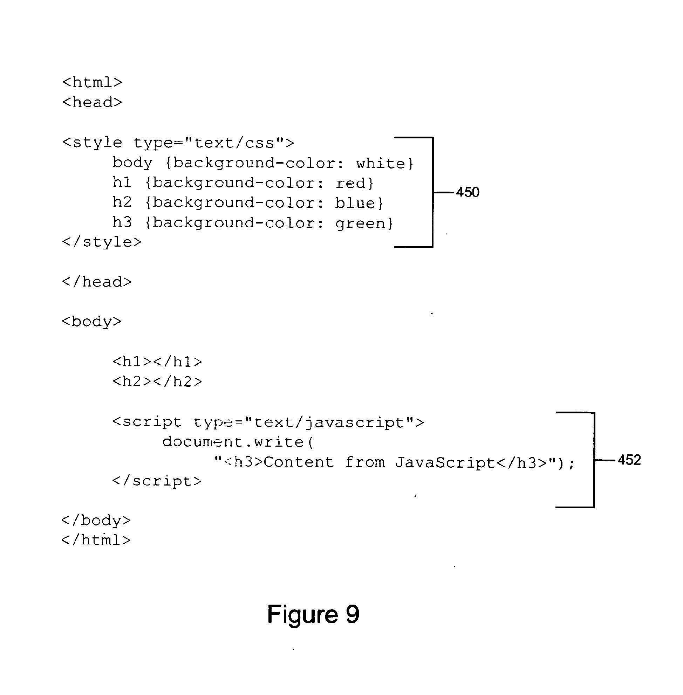

Reference is now made to Figures 8 and 9 to describe an example of data reduced at the mobile device 100, in steps 428 and 430 as described with reference to Figure 6, and at the server, in steps 414 and 416. Figure 8 shows a simplified example of data retrieved by the server and received at the mobile device 100. As shown in the present example, an HTML document includes CSS descriptions 450 and JavaScript 452 contained therein. Constituents of the data are determined to identify the displayable data and the remaining data including structure and formatting information for rendering data based on the media-type of the data (step 414). The remaining data including the structure and formatting is then extracted for use as the unit of side information for compressing data of similar media-type and data source in response to future requests (step 416). The remaining data, according to the present example, is shown in Figure 9. As shown, the reduced data in Figure 9 includes the CSS descriptions 450 and JavaScript 452. The displayable HTML data identified by the numeral 454 in Figure 8, "This is some content." and "This is some more content.", is not included in the reduced data, however. Thus, in the present example, the HTML displayable data is not included in the reduced data while the remaining data is included.

Reference is now made to Figures 6, 7 and 10 to describe a method of interactive compression including creating side information in accordance with the embodiment. Many of the steps in the present embodiment are similar to those described above with reference to Figures 6 and 7 and therefore, these steps are referred to but are not described in detail again.

A request for data is transmitted from the mobile device 100 to the server along with an indication that the mobile device 100 is YK-enabled (step 400). The mobile device 100 then awaits receipt of the requested data transmitted from the server.

The request sent from the mobile device 100 is received at the server (step 402) and the server identifies the requested data and begins retrieving the requested data (step 404). The requested data can be located within the server or can be accessible through a remote server, such as HTTP server 275, over the network 200. The server then determines the media-type as well as the data source (step 406) and the server searches the server side information database 324 to determine if a suitable unit of side information, based on the media-type and data source, is associated with the mobile device 100 (step 408). If no suitable unit of side information has been previously stored for the mobile device 100 for the identified media-type and data source, the data is compressed without the use of side information (step 410). Again, the first time data of a particular media-type and data source is requested, no side information exists in association with the mobile device 100 and therefore the data retrieved is compressed without the benefit of the use of side information.

The server then transmits a response to the mobile device 100. The compression method used is identified in the response sent to the mobile device 100 (step 412) and the requested data is transmitted. Again, the server can begin streaming the response to the mobile device 100 shortly after beginning retrieval of the requested data (when the requested data begins to arrive). It will be appreciated that there may be a minimum amount that the server retrieves before the side information is selected and before starting to transmit the data. It is not necessary that all the data be retrieved at the server prior to beginning compression and transmission of data, however.

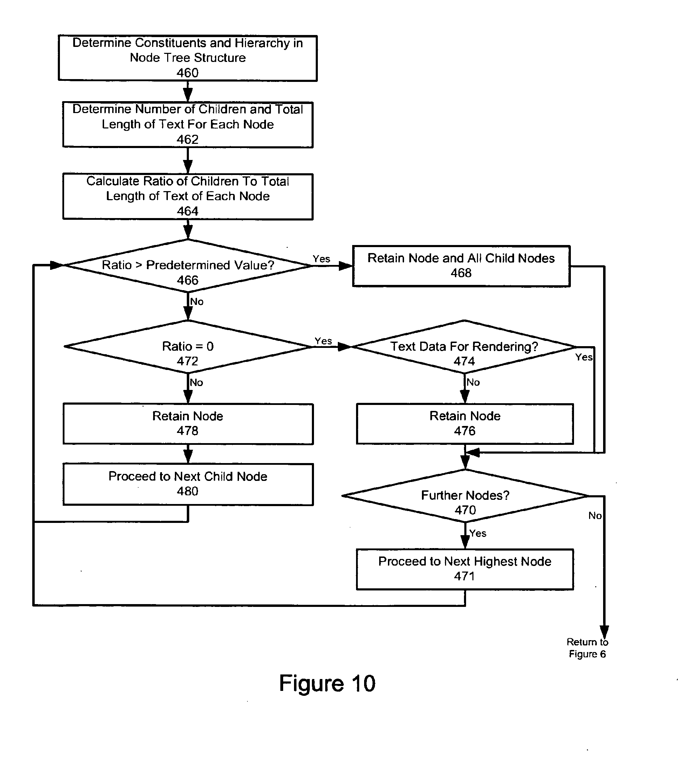

Data for retaining is then determined (step 414). In the present embodiment, the determination of data for retaining includes a number of sub-steps as shown in Figure 10. First, the constituents of the data and a hierarchical node tree structure are determined (step 460). All structure and formatting as well as data for rendering is determined based on the media-type of the data. Next, the number of children or dependent nodes in the node tree structure and the total length of text (the number of characters) for each node is determined (step 462). In the present application, child nodes include all those nodes that are directly dependent from a node and all subsequent nodes in the path (further dependent nodes). Similarly, parent nodes include the node from which a child node depends and all further nodes in the path in which the child node depends. A numerical ratio of child nodes to total length of text for rendering is also determined for each node (step 464). Next, the ratio determined for each node at step 464 is compared to a predetermined value to determine if the ratio is greater than the predetermined value, beginning with the root node of the tree structure and then traversing across the tree structure. If any one node has a ratio that exceeds the predetermined value, then it is determined that the node along with all the child nodes are to be retained (step 468). It is determined if there are further nodes in the tree (step 470) and if not, the process proceeds to the next step as shown in Figure 6 (step 416). If there are further nodes in the tree, however, the next highest node in the tree is determined (step 471) and the process returns to step 466 where it is determined if the ratio for the exceeds the predetermined value.

If at step 466 it is determined that the ratio does not exceed the predetermined value, it is then determined if the ratio is equal to zero (step 472). If the ratio is not equal to zero, it is determined that the node is to be retained (step 478), the next node that is a child node of the current node is determined (step 480) and the process returns to step 466 where it is determined if the ratio for the child node, determined at step 480, is greater than the predetermined value. If not, the process proceeds to step 472.

If, at step 472, it is determined that the ratio is equal to zero, it is then determined if the node is a node of text data for rendering (step 474). If not, it is determined that the node is to be retained (step 476) and the process proceeds to step 470. If it is determined that the node is a node of text data for rendering, the process proceeds directly to step 470. As described, it is determined if there are further nodes in the tree (step 470) and if not, the process proceeds to the next step as shown in Figure 6 (step 416). If there are further nodes in the tree, however, the next highest node in the tree is determined (step 471) and the process returns to step 466 where it is determined if the ratio for the next node exceeds the predetermined value.

The data identified in the sub-steps of step 414 to be data for retaining is then extracted for use as the unit of side information for compressing data of similar media-type and data source in response to future requests (step 416). The unique identifier is computed for the extracted data, referred to now as the unit of side information (step 418) and the unit of side information is cached (step 420), storing the unit of side information in the server side information database 324 in association with the unique identifier for use in compressing data of the same media-type and data source in response to future requests from the mobile device 100. Again, the server side information database 314 can store more than one unit of side information as units of side information apply to like data formats and data sources.

The response including the identity of the compression method used is received at the mobile device 100 (step 422) and it is determined that no side information was used to compress the data. Thus, the decoder 103 decompresses the received data and renders the data on the display 110 (step 424). The mobile device 100 determines the media-type of the requested data (step 426) and the data for retaining is determined based on the media-type of the data (step 428). In the present embodiment, the determination of data for retaining includes a number of sub-steps that are identical to those described above with reference to step 414 and to Figure 10. It will be appreciated that when it is determined that there are no further nodes at step 470, the process proceeds to step 430 where the data identified at step 428 to be data for retaining is then extracted for use as the unit of side information for compressing data of similar media-type and data source (step 430). The unique identifier is computed for the extracted data, referred to now as the unit of side information (step 432). The extracted data is used to build the grammar and collect frequency counts for compression of data (step 433) and the extracted data including the grammar and frequency counts is compressed using YK compression without the use of any side information (step 434). The compressed data including the grammar and frequency counts is cached (step 435), storing the compressed data in the device side information database 314 in association with the unique identifier for use in decompressing data of similar media-type received in response to future requests. Again, the device side information database 314 can store more than one unit of side information as units of side information apply to like data formats.

Returning to step 408, the server searches the server side information database 324 to determine if a suitable unit of side information, based on media-type and data source, is associated with the mobile device 100. The server thereby determines if a suitable unit of side information has been previously stored for the mobile device 100 for the media-type and the data source and if so, the unit of side information is retrieved along with the unique identifier, as shown in Figure 7 (step 436). According to the present embodiment, the first time data of a particular media-type and data source is requested, no side information exists in association with the mobile device 100 and therefore the data retrieved is compressed without the benefit of the use of side information. The second time data of a particular media-type and data source is requested, the server and the mobile device 100 have a unit of side information stored in association with a unique identifier in their respective side information databases 324, 314.

After retrieving the unit of side information based on the media-type and data source, along with the unique identifier of the side information, the server builds the grammar and collects frequency counts and then compresses the data (step 438). The server then transmits a response to the mobile device 100. The compression method used is identified in the response sent to the mobile device 100 along with the identifier of the unit of side information and the requested data is transmitted (step 440). As described above, rather than waiting for all of the requested data to be retrieved, the server can begin streaming the response to the mobile device 100 shortly after beginning retrieval of the requested data (when the requested data begins to arrive). After beginning transmission of the identifier of the unit of side information and the requested data, the process returns to step 414 and, as described above with reference to Figure 6 and to Figure 10, the data for retaining is determined (step 416). The process proceeds through the remaining steps 416 to 420 and the new unit of side information created from the data is cached, storing the unit of side information in the server side information database 324 in association with the unique identifier for use in compressing data of the same media-type and data source in response to future requests from the mobile device 100. Many units of side information can therefore be stored in the server side information database 324 and the side information cache size can be managed using any suitable technique. If the data sent to the mobile device 100 at step 440 is identical to data previously sent to the mobile device 100, the unit of side information cached at step 420 will be the same as a previously cached unit of side information and will have the same side information identifier. Further, if the data differs only in displayable text that is not retained for use as side information, the unit of side information will be the same as a previously cached unit of side information. Thus, only a single cache entry is stored in the server side information database 324 for the data as the unit of side information overwrites the previous unit of side information stored in association with the side information identifier.

The response including the unique identifier of the unit of side information is received at the mobile device 100 (step 442) and the unit of side information resident on the mobile device 100, in the side information database 314, is identified using the unique identifier. The decoder 103 loads the unit of side information for use in decompressing the received data (step 444) and the received data is then decompressed using the unit of side information and rendered on the display 110 (step 446).

After all the data is received and decompressed, the process returns to step 426 of Figure 6. The process proceeds through the steps 426 to 435, as described above, and the new unit of side information created from the data including the grammar and frequency counts is compressed and cached, storing the unit of side information in the device side information database 314 in association with the unique identifier for use in decompressing data of the same media-type and data source. Again, many units of side information can therefore be stored in the device side information database 314 and the side information cache size can be managed using any suitable technique.

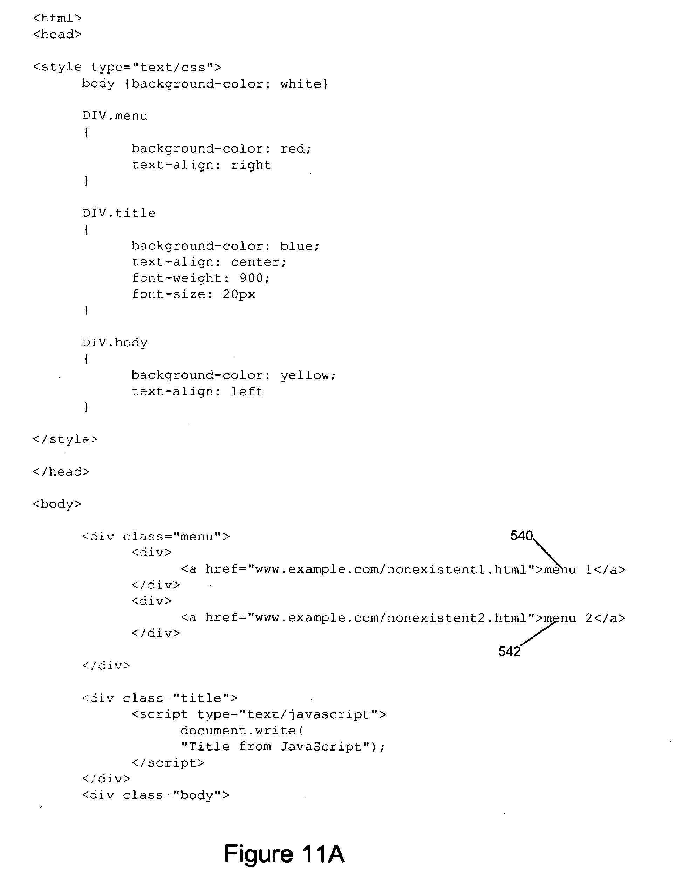

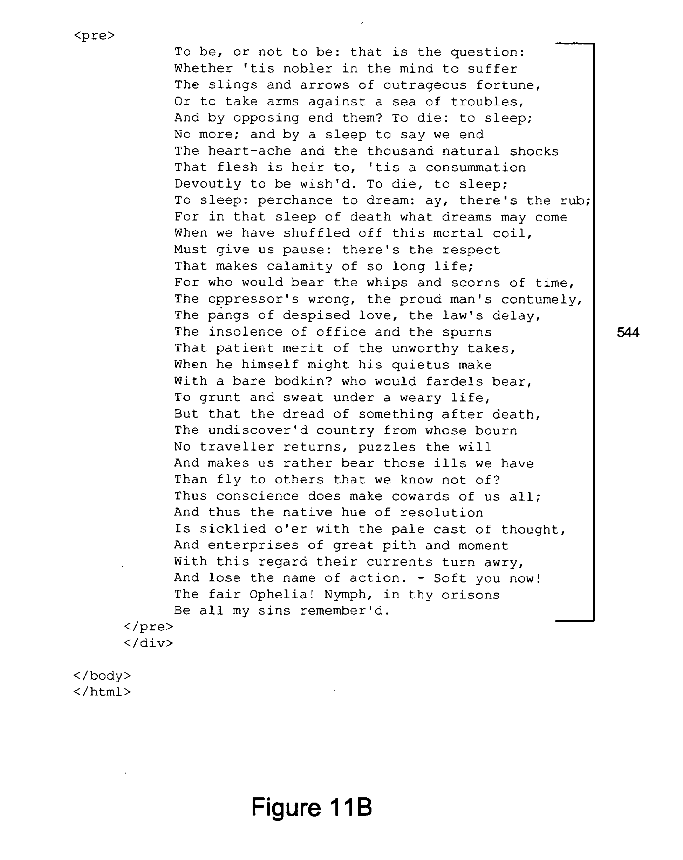

Reference is now made to Figures 11 to 15 with continued reference to Figures 6, 7 and 10 to describe an example of interactive compression including creating side information in accordance with the present embodiment. Figures 11A and 11B show one example of data requested by the mobile device 100 in the request for data transmitted at step 400. The data shown in Figure 11B is a continuation of data from Figure 11A and is shown on a second page as a result of the length of the combined data only.

The request for data is received at the server along with the indication that the mobile device 100 is YK-enabled (step 402) and the server begins retrieving the requested data (step 404). The server then determines the media-type as well as the data source (step 406) and the server searches the server side information database 324 to determine if a suitable unit of side information, based on the media-type and data source, is associated with the mobile device 100 (step 408). In the present example, no suitable unit of side information has been previously stored for the mobile device 100 for the identified media-type and data source, the data is compressed without the use of side information (step 410).

The server then transmits a response to the mobile device 100. The compression method used is identified in the response sent to the mobile device 100 (step 412) and the requested data is transmitted. Again, the server can begin streaming the response to the mobile device 100 shortly after beginning retrieval of the requested data (when the requested data begins to arrive).

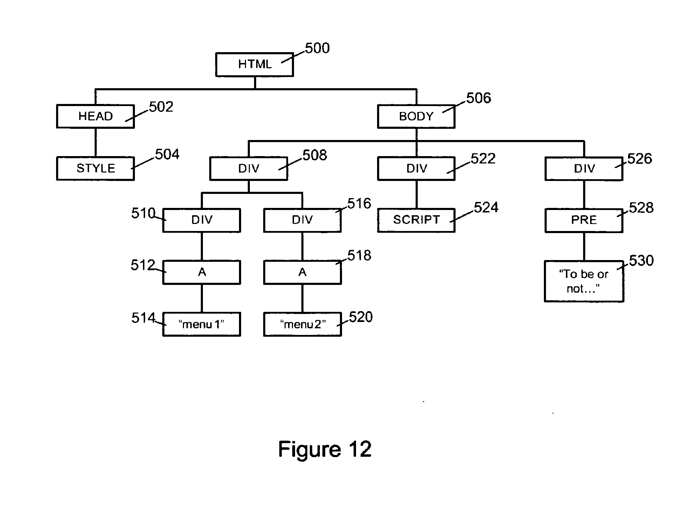

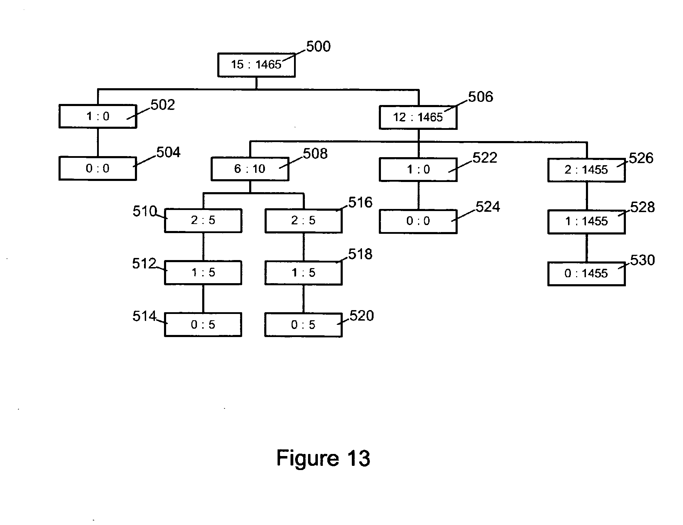

Data for retaining is then determined (step 414). First, the constituents of the data and a hierarchical node tree structure are determined (step 460). In the present example, the data shown in Figures 11A and 11B can be represented in the node tree shown in Figure 12 including the root node 500 representing the data format (HTML) and nodes 502 to 530 that represent all structure and formatting as well as text data for rendering. Thus, all structure and formatting as well as data for rendering is determined based on the data format. Next, the number of children or dependent nodes and the total length of text for rendering (the number of characters) for each node is determined (step 462). A numerical ratio of child nodes to total length of text is determined for each node (step 464). The ratios for each node are represented in node tree shown in Figure 13. The node tree of Figure 13 is identical to that of Figure 12, with ratios inserted for the purpose of the present description. As shown, the root node, 500 includes 15 child nodes and a total length of text for rendering of 1465 characters. The node 502 includes 1 child node and 0 text for rendering. It will be appreciated that the nodes 514, 520, and 530 represent the text for rendering 540, 542 and 544, respectively, shown in Figures 11A and 11B. The remainder of the nodes in the tree represent non-text nodes.

Next, the ratio determined for each node at step 464 is then compared to a predetermined value to determine if the ratio is greater than the predetermined value, beginning with the root node of the tree structure. The predetermined value can be any suitable value. In the present example, the predetermined value is 0.1. The root node has a ratio of 15:1465, which is equal to 0.01. This number is not greater than the predetermined value. The ratio does not equal zero, however (step 472). Thus, the node is identified as a node for retaining (step 478) and the process proceeds to the next child node (step 480). The next child node is the node 502 which has a ratio of 1:0, which is an infinite number. Thus, the node 502 and all child nodes (node 504) are identified as nodes for retaining (step 468). There are further nodes (step 470) and therefore, the process proceeds to the next highest node (step 471), which in the present example is the node 506 representing the "BODY". The node 506 has a ratio of 12:1465, which is equal to 0.008. This ratio does not exceed 0.1 (step 466) and the ratio is not equal to zero (step 478). Thus, the node is identified as a node for retaining (step 478) and the process proceeds to the next child node (step 480) which, in the present example, is the node 508. The node 508 has a ratio of 6:10 that equals 0.6. This value exceeds the predetermined value of 0.1 (step 466) and therefore this node along with all child nodes 510, 512, 514, 516, 518, and 520 are identified as nodes for retaining (step 468). There are further nodes (step 470) and therefore, the process proceeds to the next highest node (step 471). The node 522 has a ratio of 1:0, which is an infinite number. Thus, the node 522 and all child nodes (node 524) are identified as nodes for retaining (step 468). There are further nodes (step 470) and therefore, the process proceeds to the next highest node (step 471), which in the present example is the node 526. The node 526 has a ratio of 2:1455, which is equal to 0.001. This number is not greater than the predetermined value (step 466). The ratio does not equal zero, however (step 472). Thus, the node is identified as a node for retaining (step 478) and the process proceeds to the next child node (step 480). The node 528 has a ratio of 1:1455, which is less than 0.001. This number is not greater than the predetermined value (step 466). The ratio does not equal zero, however (step 472). Thus, the node is identified as a node for retaining (step 478) and the process proceeds to the next child node (step 480). Finally, the node 530 has a ration of 0:1455, which is equal to 0. This number is not greater than the predetermined value (step 466) and is determined to be equal to zero (step 472). The node is determined to be text data for rendering at step 474 and therefore the process proceeds to step 470. At step 470 it is determined that there are no further nodes in the node tree and the process continues at step 416.

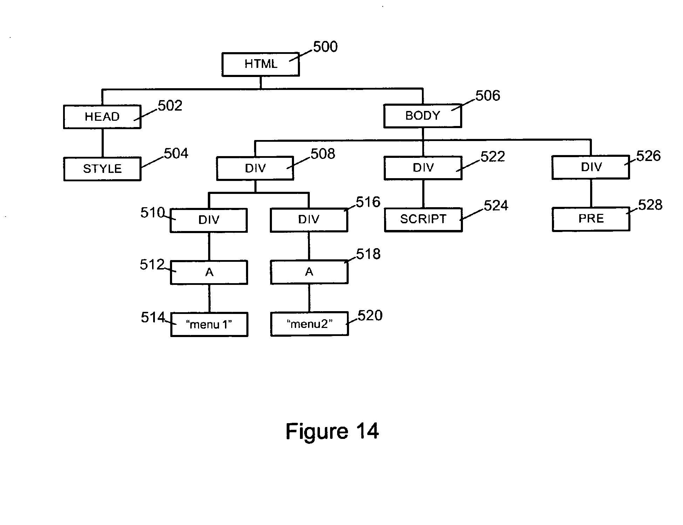

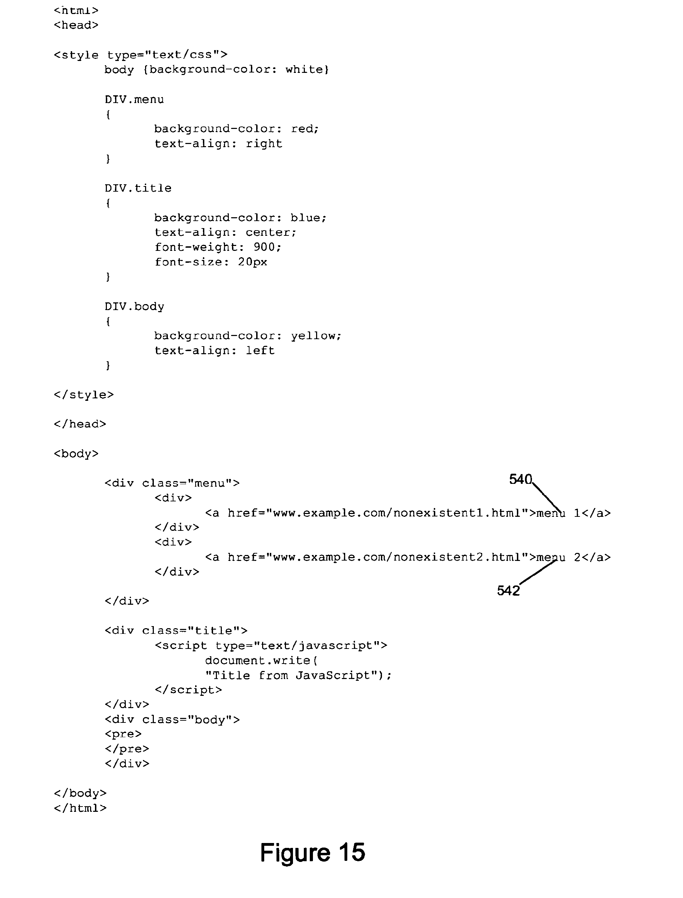

The data identified at step 414 to be data for retaining is then extracted for use as the unit of side information for compressing data of similar media-type and data source in response to future requests (step 416). The extracted data for use as the unit of side information is represented in the tree structure shown in Figure 14 and is shown in Figure 15. It will be appreciated that in the present embodiment, all data was retained for use as the unit of side information with the exception of the text data represented by the number 530 and corresponding the text 544 in Figure 11B. The unique identifier is computed for the extracted data, referred to now as the unit of side information (step 418) and the unit of side information is cached (step 420), storing the unit of side information in the server side information database 324 in association with the unique identifier for use in compressing data of the same media-type and data source in response to future requests from the mobile device 100.

The response including the identity of the compression method used is received at the mobile device 100 (step 422) and it is determined that no side information was used to compress the data. Thus, the decoder 103 decompresses the received data and renders the data on the display 110 (step 424). The mobile device 100 determines the media-type of the requested data (step 426) and the data for retaining is determined based on the media-type of the data (step 428). In the present embodiment, the determination of data for retaining includes a number of sub-steps that are identical to those described above with reference to step 414 and to Figures 10 to 15. It will be appreciated that when it is determined that there are no further nodes at step 470, the process proceeds to step 430 where the data identified at step 428 to be data for retaining is then extracted for use as the unit of side information for compressing data of similar media-type and data source (step 430). The unique identifier is computed for the extracted data (step 432). The extracted data is used to build the grammar and collect frequency counts for compression of data (step 433) and the extracted data including the grammar and frequency counts is compressed using YK compression without the use of any side information (step 434). The compressed data including the grammar and frequency counts is cached (step 435), storing the compressed data in the device side information database 314 in association with the unique identifier for use in decompressing data of similar media-type received in response to future requests. Again, the device side information database 314 can store more than one unit of side information as units of side information only apply to like data formats.

It will be appreciated that if the server determined at step 408 that a suitable unit of side information, based on the media-type and data source, is associated with the mobile device, the data transmitted to the mobile device would have been compressed at the server side using the suitable unit of side information and decompressed at the mobile device 100 using the corresponding unit of side information, as shown in Figure 7.

In the embodiment and the example described above with reference to Figure 6, 7 and 10, data is sent to the mobile device in response to receipt of a request for data. It will be appreciated that data such as email data can be sent to the mobile device 100 in a "push" operation, and therefore, a unit of side information is selected and the data is compressed and sent automatically without receipt of a request for data at the server. Thus, a request for data is not sent from the mobile device 100 as described.

It will be appreciated that, in the embodiment described above with reference to Figure 10, some text for rendering is retained. In the example described above, the text nodes 514 and 520 are retained. Thus, the corresponding text 540, 542 respectively is retained in the unit of side information. This is particularly advantageous as the text nodes that are retained are likely to be shared between data from the same source. In the above HTML example, the nodes 514 and 520 are likely to be shared with HTML documents from the same source, for example from the same domain, and therefore the inclusion of this text data in the side information improves compression using this side information. In a particular example, a news Web site may contain a Web page that includes text in articles as well as links to other pages within the site such as "World", "Sports" and "Finance". While the text in the articles is likely to vary, the text in the links is likely to be the same as that of other Web pages within the site. The inclusion of this text further improves compression.

In the embodiments described above with reference to Figures 6 and 7, the grammar is built and statistics compiled and the side information is compressed at the mobile device 100 prior to storing in the device side information database 314. It will be appreciated that, instead, the grammar can be built and statistics compiled "on the fly" rather than prior storing the side information in the device side information database 314. Further, the side information can be stored without compression. It will also be appreciated that the grammar can be built and statistics compiled prior to storing the side information in the server side information database 324 rather than building grammar and compiling statistics after retrieving the side information from the database during a compression operation.

In the present application, application-layer data compression is performed for compressing, for example, Web page content or email content. Data transmitted in a mobile device/server system in which a server asynchronously transmits data to one or more mobile devices or in which a mobile device requests data from one or more servers can be compressed using a compression method employing side information such as Yang-Kieffer (YK) compression. The side information is implemented as a shared-state between the data compressor (encoder) and the data decompressor (decoder). The use of side information in such a compression method can provide marked improvements in data compression rates, resulting in network bandwidth savings when the data is transmitted.

Reducing the side information can result in a significant reduction in the size of the unit of side information while preserving the portions of the document most likely to be common across other documents of the same media-type and originating from the same source. The reduction in size of the unit of side information results in a significant reduction in RAM used in the RAM constrained mobile device during decompression of data at the decoder. It will be appreciated that, for example, many pages within a website may have very similar layout and formatting and, as a result, share many blocks of HTML, CSS-style descriptions, and JavaScript code. The most significant differences may be in displayable data of the pages. By removing at least some of the displayable data in the side information used for compression and decompression, significant reductions in RAM used can be realized while still benefiting from improved compression as a result of the use of the reduced side information.

Embodiments of the disclosure may be represented as a software product stored in a machine-readable medium (also referred to as a computer-readable medium, a processor-readable medium, or a computer usable medium having a computer readable program code embodied therein). The machine-readable medium may be any suitable tangible medium, including magnetic, optical, or electrical storage medium including a diskette, compact disk read only memory (CD-ROM), memory device (volatile or non-volatile), or similar storage mechanism. The machine-readable medium may contain various sets of instructions, code sequences, configuration information, or other data, which, when executed, cause a processor to perform steps in a method according to an embodiment of the disclosure. Those of ordinary skill in the art will appreciate that other instructions and operations necessary to implement the described embodiments may also be stored on the machine-readable medium. Software running from the machine-readable medium may interface with circuitry to perform the described tasks.

The above-described embodiments of the present disclosure are intended to be examples only. Alterations, modifications and variations may be effected to the particular embodiments by those of skill in the art without departing from the scope which is defined solely by the claims appended hereto.

## Claims

1. A computer-implemented method of creating side information from data to use in interactive compression, the method comprising:
identifying constituents of the data comprising displayable data including text that is rendered, and structure and formatting information;
determining a hierarchical node tree structure for the identified constituents of the data;
determining, for each node in the node-tree structure, a ratio of a number of child nodes of that node to a total length of text data for that node and the child nodes of that node;
determining ones of the constituents of the data to retain to use as a unit of side information based on the ratio such that each node and the respective child nodes are retained when the ratio for the node exceeds a predetermined value, each node for which the ratio is not zero is retained, and each node that is not a node of text data for rendering and for which the ratio is equal to zero is retained; and
extracting and retaining the determined ones of the constituents of the data to use as a unit of side information.

2. The method according to claim 1, further comprising storing the unit of side information in a memory unit.

3. The method according to claim 1 or 2, further comprising identifying a media-type of the data prior to identifying constituents of the data.

4. The method according to claim 1, 2 or 3 further comprising computing a unique side information identifier to identify the unit of side information.

5. The method according to claim 4, further comprising storing the unit of side information in a memory unit in association with the unique side information identifier.

6. The method according to claim 4 or 5, wherein the unique side information identifier comprises a hash of the unit of side information.

7. The method according to claim 6, wherein the unique side information identifier comprises at least one of a length of the unit of side information in bytes, a modification date and time of the unit of side information, a version number, and a randomly generated number.

8. The method according to any preceding claim, further comprising sending the data to another electronic device to create a unit of side information at the other electronic device to use in the interactive compression.

9. The method according to any of claims 1-8, further comprising sending the unit of side information to another electronic device to use in the interactive compression.

10. The method according to any preceding claim, further comprising receiving the data from a host server system to create the unit of side information.

11. The method according to claim 10, further comprising receiving a unique identifier to compare to a computed unique identifier to confirm that the data used to create the unit of side information is identical at the host system.

12. The method according to any preceding claim, further comprising building grammar and frequency counts, from the determined ones of the constituents of the data that are extracted, to compress the data.

13. A mobile device (100) comprising:
a housing;
a display device (110) exposed by the housing;
an input device;
a memory unit (106, 108) within the housing; and
a processor (102) within the housing and operably connected to the display device (110), the input device and the memory unit (106, 108), the process (102) being configured to execute a program stored in the memory unit (106, 108) to cause the electronic mobile device (100) to perform a method in accordance with any preceding claim.

14. A computer program product comprising a computer-readable medium having computer-readable code embodied therein executable by a processor (102) of a mobile device (100) to cause the device to perform a method in accordance with any of claims 1-12.

## Patentansprüche

1. Ein computerimplementiertes Verfahren zum Erzeugen von Nebeninformation aus Daten zur Verwendung bei einer interaktiven Komprimierung, wobei das Verfahren aufweist:
Identifizieren von Bestandteilen der Daten, die anzeigbare Daten mit Text, der dargestellt wird, und Struktur- und Formatierungsinformation aufweisen;
Bestimmen einer hierarchischen Knoten-Baumstruktur für die identifizierten Bestandteile der Daten;
Bestimmen, für jeden Knoten in der Knoten-Baumstruktur, eines Verhältnisses einer Anzahl von Kind-Knoten dieses Knotens zu einer Gesamtlänge von Textdaten für diesen Knoten und die Kind-Knoten dieses Knotens;
Bestimmen von einem oder mehreren Bestandteil(en) der Daten, die zu behalten sind, zur Verwendung als eine Einheit von Nebeninformation basierend auf dem Verhältnis derart, dass jeder Knoten und die jeweiligen Kind-Knoten behalten werden, wenn das Verhältnis für den Knoten einen vorgegebenen Wert übersteigt, wobei jeder Knoten, für den das Verhältnis nicht Null ist, behalten wird, und jeder Knoten, der kein Knoten von Textdaten zur Darstellung ist und für den das Verhältnis gleich null ist, behalten wird; und
Extrahieren und Behalten der bestimmten der Bestandteile der Daten zur Verwendung als eine Einheit von Nebeninformation.

2. Das Verfahren gemäß Anspruch 1, das weiter aufweist ein Speichern der Einheit von Nebeninformation in einer Speichereinheit.

3. Das Verfahren gemäß Anspruch 1 oder 2, das weiter aufweist ein Identifizieren eines Media-Typs der Daten vor dem Identifizieren von Bestandteilen der Daten.

4. Das Verfahren gemäß Anspruch 1, 2 oder 3, das weiter aufweist ein Berechnen eines eindeutigen Nebeninformations-Identifizierers zum Identifizieren der Einheit von Nebeninformation.

5. Das Verfahren gemäß Anspruch 4, das weiter aufweist ein Speichern der Einheit von Nebeninformation in einer Speichereinheit in Verbindung mit dem eindeutigen Nebeninformations-Identifizierer.

6. Das Verfahren gemäß Anspruch 4 oder 5, wobei der eindeutige Nebeninformations-Identifizierer einen Hash der Einheit von Nebeninformation aufweist.

7. Das Verfahren gemäß Anspruch 6, wobei der eindeutige Nebeninformations-Identifizierer zumindest eines aus einer Länge der Einheit von Nebeninformation in Bytes, ein Modifikations-Datum und -Zeit der Einheit von Nebeninformation, einer Versionsnummer, und eine zufällig erzeugte Zahl aufweist.

8. Das Verfahren gemäß einem vorhergehenden Anspruch, das weiter aufweist ein Senden der Daten an eine andere elektronische Vorrichtung zum Erzeugen einer Einheit von Nebeninformation an der anderen elektronischen Vorrichtung zur Verwendung bei der interaktiven Komprimierung.

9. Das Verfahren gemäß einem der Ansprüche 1-8, das weiter aufweist ein Senden der Einheit von Nebeninformation an eine andere elektronische Vorrichtung zur Verwendung bei der interaktiven Komprimierung.

10. Das Verfahren gemäß einem vorhergehenden Anspruch, das weiter aufweist ein Empfangen der Daten von einem Host-Server-System zum Erzeugen der Einheit von Nebeninformation.

11. Das Verfahren gemäß Anspruch 10, das weiter aufweist ein Empfangen eines eindeutigen Identifizierers zum Vergleichen mit einem berechneten eindeutigen Identifizierer, um zu bestätigen, dass die Daten, die zum Erzeugen der Einheit von Nebeninformation verwendet werden, an dem Hostsystem identisch sind.

12. Das Verfahren gemäß einem vorhergehenden Anspruch, das weiter aufweist ein Erstellen von Grammatik- und Häufigkeits-Zahlen aus den bestimmten der Bestandteile der Daten, die extrahiert werden, um die Daten zu komprimieren.

13. Eine mobile Vorrichtung (100), die aufweist:
ein Gehäuse;
eine Anzeigevorrichtung (110), die durch das Gehäuse exponiert wird;
eine Eingabevorrichtung;
eine Speichereinheit (106, 108) in dem Gehäuse; und
einen Prozessor (102) in dem Gehäuse und betriebsfähig mit der Anzeigevorrichtung (110), der Eingabevorrichtung und der Speichereinheit (106, 108) verbunden, wobei der Prozessor (102) konfiguriert ist zum Ausführen eines Programms, das in der Speichereinheit (106, 108) gespeichert ist, um die elektronische mobile Vorrichtung (100) zu veranlassen, ein Verfahren gemäß einem vorhergehenden Anspruch durchzuführen.

14. Ein Computerprogrammprodukt, das ein computerlesbares Medium mit darin aufgenommenem computerlesbaren Code aufweist, der durch einen Prozessor (102) einer mobilen Vorrichtung (100) ausführbar ist, um die Vorrichtung zu veranlassen, ein Verfahren gemäß einem der Ansprüche 1-12 durchzuführen.

## Revendications

1. Procédé mis en oeuvre par ordinateur de création d'informations annexes à partir de données à utiliser en compression interactive, le procédé comprenant :
l'identification de constituants des données comprenant des données affichables comprenant un texte qui est rendu, et des informations de structure et de formatage ;
la détermination d'une structure d'arbre de noeuds hiérarchique pour les constituants identifiés des données ;
la détermination, pour chaque noeud dans la structure d'arbre de noeuds, d'un rapport d'un nombre de noeuds enfants de ce noeud sur une longueur totale de données de texte pour ce noeud et les noeuds enfants de ce noeud ;
la détermination de ceux des constituants des données à conserver à utiliser comme une unité d'informations annexes sur la base du rapport de sorte que chaque noeud et les noeuds enfants respectifs soient conservés lorsque le rapport pour le noeud dépasse une valeur prédéterminée, chaque noeud pour lequel le rapport n'est pas zéro est conservé, et chaque noeud qui n'est pas un noeud de données de texte pour le rendu et pour lequel le rapport est égal à zéro est conservé ; et
l'extraction et la conservation de ceux déterminés des constituants des données à utiliser comme une unité d'informations annexes.

2. Procédé selon la revendication 1, comprenant en outre le stockage de l'unité d'informations annexes dans une unité de mémoire.

3. Procédé selon la revendication 1 ou 2, comprenant en outre l'identification d'un type de média des données avant l'identification de constituants des données.

4. Procédé selon la revendication 1, 2 ou 3, comprenant en outre le calcul d'un identificateur d'informations annexes unique pour identifier l'unité d'informations annexes.

5. Procédé selon la revendication 4, comprenant en outre le stockage de l'unité d'informations annexes dans une unité de mémoire en association avec l'identificateur d'informations annexes unique.

6. Procédé selon la revendication 4 ou 5, dans lequel l'identificateur d'informations annexes unique comprend un hachage de l'unité d'informations annexes.

7. Procédé selon la revendication 6, dans lequel l'identificateur d'informations annexes unique comprend au moins un parmi une longueur de l'unité d'informations annexes en octets, une date et une heure de modification de l'unité d'informations annexes, un numéro de version et un nombre généré de façon aléatoire.

8. Procédé selon l'une quelconque des revendications précédentes, comprenant en outre l'envoi des données à un autre dispositif électronique pour créer une unité d'informations annexes au niveau de l'autre dispositif électronique à utiliser dans la compression interactive.

9. Procédé selon l'une quelconque des revendications 1 à 8, comprenant en outre l'envoi de l'unité d'informations annexes à un autre dispositif électronique à utiliser dans la compression interactive.

10. Procédé selon l'une quelconque des revendications précédentes, comprenant en outre la réception des données en provenance d'un système de serveur hôte pour créer l'unité d'informations annexes.

11. Procédé selon la revendication 10, comprenant en outre la réception d'un identificateur unique à comparer à un identificateur unique calculé pour confirmer que les données utilisées pour créer l'unité d'informations annexes sont identiques au niveau du système hôte.

12. Procédé selon l'une quelconque des revendications précédentes, comprenant en outre la construction de grammaire et de nombres d'occurrences, à partir de ceux déterminés des constituants des données qui sont extraits, pour compresser les données.

13. Dispositif mobile (100) comprenant :
un boîtier ;
un dispositif d'affichage (110) exposé par le boîtier ;
un dispositif d'entrée ;
une unité de mémoire (106, 108) à l'intérieur du boîtier ; et
un processeur (102) à l'intérieur du boîtier et connecté fonctionnellement au dispositif d'affichage (110), au dispositif d'entrée et à l'unité de mémoire (106, 108), le processeur (102) étant configuré pour exécuter un programme stocké dans l'unité de mémoire (106 , 108) pour amener le dispositif mobile électronique (100) à effectuer un procédé conformément à l'une quelconque des revendications précédentes.

14. Produit de programme informatique comprenant un support lisible par ordinateur ayant un code lisible par ordinateur incorporé dans celui-ci exécutable par un processeur (102) d'un dispositif mobile (100) pour amener le dispositif à effectuer un procédé conformément à l'une quelconque des revendications 1 à 12.
